(19) Europäisches Patentamt
European Patent Office
Office européen des brevets

(11) **EP 2 587 551 B1**

(12) **EUROPEAN PATENT SPECIFICATION**

(45) Date of publication and mention
of the grant of the patent:
**30.09.2015 Bulletin 2015/40**

(51) Int Cl.:
*H01L 31/042* (2014.01)    *C08K 5/54* (2006.01)
*C08L 23/08* (2006.01)    *C09K 3/10* (2006.01)

(21) Application number: **11800729.3**

(22) Date of filing: **24.06.2011**

(86) International application number:
**PCT/JP2011/064509**

(87) International publication number:
**WO 2012/002264 (05.01.2012 Gazette 2012/01)**

(54) **SOLAR CELL SEALING MATERIAL, AND SOLAR CELL MODULE USING SAME**

SOLARZELLENDICHTMATERIAL UND UNTER DEREN VERWENDUNG HERGESTELLTES SOLARZELLENMODUL

MATÉRIAU D'ÉTANCHÉITÉ POUR CELLULE SOLAIRE ET MODULE DE CELLULES SOLAIRES UTILISANT LEDIT MATÉRIAU

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.06.2010 JP 2010146311**

(43) Date of publication of application:
**01.05.2013 Bulletin 2013/18**

(73) Proprietor: **Japan Polyethylene Corporation Tokyo 100-8251 (JP)**

(72) Inventors:
• **AMAMIYA Takahiro**
**Kawasaki-shi**
**Kanagawa 210-8548 (JP)**
• **ONAKA Tamami**
**Kawasaki-shi**
**Kanagawa 210-8548 (JP)**
• **MAEYAMA Tomoaki**
**Kawasaki-shi**
**Kanagawa 210-8548 (JP)**
• **MATSUMOTO Takuya**
**Kawasaki-shi**
**Kanagawa 210-8548 (JP)**

(74) Representative: **Hoffmann Eitle**
**Patent- und Rechtsanwälte PartmbB**
**Arabellastraße 30**
**81925 München (DE)**

(56) References cited:
WO-A1-2006/057361    WO-A1-2009/125685
WO-A1-2009/125685    WO-A1-2010/131716
WO-A2-2008/036708    US-A1- 2002 038 664

**Description**

TECHNICAL FIELD

The present invention relates to a solar cell encapsulant and a solar cell module using the same, and in more detail, relates to the solar cell encapsulant containing an ethylene·α-olefin copolymer and a copolymer of ethylene-a functional group-containing monomer, having good productivity, superior transparency and light transmittance, and also superior flexibility, heat resistance, adhesive property and steam transmittance resistance, and the solar cell module using the same.

BACKGROUND ART

In the midst of close-up of a global environmental problem such as increase in carbon dioxide, photovoltaic power generation has been drawn attention again, as well as effective utilization of hydraulic power, wind power, geothermal heat or the like.

The photovoltaic power generation is the one using a packaged solar cell module, obtained in general by protecting a solar cell element of silicon, gallium-arsenic, copper-indium-selenium or the like with an upper transparent protecting material and a lower substrate protecting material, and fixing the solar cell element and the protecting material with an encapsulant made of a resin, and since it can be arranged in a decentralized state at a place where electric power is necessary, although scale thereof is smaller as compared with hydraulic power or wind-power or the like, research and development has been promoted aiming at performance enhancement of power generation efficiency or the like, and price reduction. In addition, by adoption of a policy to subsidize the installment cost, as an introduction promotion business of a residential house photovoltaic power generation system by state or local governments, prevalence thereof has gradually been progressing. However, still more cost reduction is required for further prevalence thereof, and accordingly, effort has been continued in a step-by-step fashion not only to develop the solar cell element using a novel material instead of conventional-type silicon or gallium-arsenic, but also to further reduce production cost of the solar cell module.

As requisite of the solar cell encapsulant composing the solar cell module, good transparency has been required, so as not to decrease power generation efficiency of a solar cell, and to secure incidence amount of sunlight. In addition, the solar cell module is usually installed outdoors, which raises temperature caused by exposure to sunlight for a long period of time. To avoid such a trouble as deformation of the module by flowing of the encapsulant made of a resin, caused by increase in temperature, it should be the one having heat resistance. In addition, thinning trend has been progressing year by year, to reduce material cost of the solar cell element, and the encapsulant superior in still more flexibility has also been required.

In addition, the solar cell module, as described above, will increase temperature when exposed to sunlight for a long period of time, resulting in decreased adhesive strength between a glass substrate and the encapsulant made of a resin, separation of the encapsulant made of a resin from the glass substrate, intrusion of air or moisture in a space thereof, or deformation of the module, therefore, to prevent this, the encapsulant superior in adhesive property has been required.

At present, as the encapsulant of the solar cell element in the solar cell module, an ethylene·vinyl acetate copolymer has generally been adopted as a resin component. As in PATENT LITERATURE 1, an organic peroxide is generally blended in this resin composition and the solar cell module has been produced by cross-linking.

In recent years, to suppress production cost of the solar cell module, it has been required to further shorten time required in the encapsulation work, and in PATENT LITERATURE 2, the solar cell encapsulant has been proposed, which is composed of an amorphous or low crystalline α-olefin-based copolymer with a crystallinity of 40% or lower, instead of the ethylene·vinyl acetate copolymer of a resin component of the encapsulant. In this PATENT LITERATURE 2, there has been exemplified the production of a sheet at a processing temperature of 100°C, using a profile extruder, by mixing the organic peroxide to an amorphous or low crystalline ethylene·butene copolymer, however, because of increased resin pressure, sufficient productivity has not been obtained.

On the other hand, when the ethylene vinyl acetate copolymer is used as the solar cell encapsulant, yellowing caused by light or heat is feared. It is because yellowing of the solar cell encapsulant decreases light transmittance, and generates a trouble of decrease or the like in conversion efficiency of the solar cell.

Accordingly, there has been proposed a composition for the solar cell encapsulant, using a polymer blend or a polymer alloy composed of a polyolefin-based copolymer and a crystalline polyolefin (see PATENT LITERATURE 3).

In this way, heat resistance, creep resistance and scratch resistance may be improved, however, diffused reflection occurs at the boundary between both polymers and transparency of a sheet decreases, because melting point (DSC method) of the crystalline polyolefin is 110°C to 170°C, and crystallinity thereof differs from that of the low crystalline polyolefin-based copolymer.

In addition, there has been proposed a cover film for the solar cell, having any one kind of an ethylene·α-olefin copolymer, a polyvinyl butyral, an ethylene-methyl acrylate copolymer, and a silicone resin, as a main component, and still more containing a cross-linking agent or the like, and a production method thereof (PATENT LITERATURE 4). In this way, resin performance and productivity enhance, and resource saving and cost reduction can be expected. However, in Examples, the above resin is used alone, which does not satisfy productivity, heat resistance, transparency, flexibility, durability and adhesive property to glass, at the same time.

In addition, as the encapsulant of the solar cell module, there has been proposed a polymer material containing an polyolefin copolymer which satisfies one or more requisites among (a) a density of less than about 0.90 g/cc, (b) a 2% secant modulus of less than about 150 megapascal (mPa), measured in accordance with ASTM D-882-02, (c) a melting point of lower than about 95°C, (d) an α-olefin content of about 15% to 50% by weight based on weight of a polymer, (e) a Tg of lower than about -35°C and (f) an SCBDI of at least about 50 (see PATENT LITERATURE 5).

In the solar cell module, there is tendency for also the solar cell encapsulant to become thinner accompanying with thinning of the solar cell element. In this case, it has been a problem of easy break of a wiring caused when impact is applied thereto from the upper protecting material side or the lower protecting material side of the solar cell encapsulant. In order to improve this problem, it is required to increase the rigidity of the encapsulant, however, the polymer material of PATENT LITERATURE 5 had a problem to deteriorate the cross-linking efficiency, when increased the rigidity.

In this way, conventional technology has not provided the resin composition for the solar cell encapsulant with enhanced productivity of the solar cell module, superior transparency, and also superior heat resistance, flexibility, durability and adhesive property to the glass substrate.

CITATION LIST

PATENT LITERATURE

PATENT LITERATURE 1: JP-A-9-116182
PATENT LITERATURE 2: JP-A-2006-210906
PATENT LITERATURE 3: JP-A-2001-332750
PATENT LITERATURE 4: JP-A-2000-91611
PATENT LITERATURE 5: JP-A-2010-504647

EP-A-2270077 (WO-A-2009/125685) discloses sealing sheets for solar cells with surface layers of blends of 80 wt% VLDPE ethylene glycidyl methacrylate. WO-A-2008/36708 discloses blends of grafted polyethylene and low density polyethylene

WO-A-2010/131716 (US-A-2012/48354) discloses sealing sheets for solar cells. Various examples disclose blends of ethylene copolymers and ethylene glycidyl and vinylacetate terpolymer.

SUMMARY OF INVENTION

TECHNICAL PROBLEM

In view of the above conventional technical problems, it is an object of the present invention to provide the solar cell encapsulant, having good productivity, superior transparency and light transmittance, and also superior flexibility, heat resistance, adhesive property and steam transmittance resistance, and the solar cell module using the same.

SOLUTION TO PROBLEM

The present inventors have intensively studied a way to solve the above-described problems and obtained knowledge that the solar cell encapsulant superior in transparency and light transmittance, and also superior in flexibility, heat resistance, adhesive property and steam transmittance resistance can be obtained by making resin components with combining an ethylene α-olefin copolymer having specific property and a copolymer of ethylene-a functional group-containing monomer, and by using a resin composition blended with additives such as the organic peroxide, as needed, and by using this, productivity of the solar cell module can be enhanced drastically, and have thus completed the present invention.

That is, according to a first aspect of the present invention, there is provided the solar cell encapsulant, characterized by using the resin composition comprising a component (A) and a component (B), satisfying the following expression (x), as resin components.

Component A; an ethylene·$\alpha$-olefin copolymer having characteristics of the following (a1)

(a1) a density of 0.860 to 0.900 g/cm$^3$

Component (B): a copolymer of ethylene-a functional group-containing monomer Component (C): a silane coupling agent Component (D): an organic peroxide

Expression (x) -480×[d]+425 ≤ [CM] ≤ -480×[d]+433 (wherein [d] represents density of the component (A); and [CM] represents comonomer content (mol%) of the component (B)).

In addition, according to a second aspect of the present invention, there is provided the solar cell encapsulant, characterized in that, in the first aspect, the component (A) is the ethylene·$\alpha$-olefin copolymer having further the following characteristics (a2).

(a2) a ratio, (Mz/Mn), of Z average molecular weight (Mz) and number average molecular weight (Mn), determined by a gel permeation chromatography (GPC), is 8.0 or less.

In addition, according to a third aspect of the present invention, there is provided the solar cell encapsulant, characterized in that, in the first aspect or the second aspect, the resin component satisfies the following expression (x').

Expression (x') -480×[d]+426 ≤ [CM] ≤ -480×[d]+432 (wherein [d] represents density of the component (A); and [CM] represents comonomer content (mol%) of the component (B)).

In addition, according to a fourth aspect of the present invention, there is provided the solar cell encapsulant, characterized in that, in any of the first to the third aspects, the component (A) has further the following characteristics (a3).

(a3) a branch number (N) derived from a comonomer in a polymer satisfying the following expression (a).

$$\text{Expression (a):} \quad N \geq -0.67 \times E + 53$$

(wherein N represents the branch number per 1000 carbon atoms in a main chain and a side chain in total, measured by NMR; and E represents modulus of elasticity in tension of a sheet-like resin composition, measured in accordance with ISO1184-1983).

In addition, according to a fifth aspect of the present invention, there is provided the solar cell encapsulant, characterized in that, in the fourth aspect, the component (A) satisfies the following expression (a').

$$\text{Expression (a'):} \quad -0.67 \times E + 100 \geq N \geq -0.67 \times E + 53$$

(wherein N represents the branch number per 1000 carbon atoms in a main chain and a side chain in total, measured by NMR; and E represents modulus of elasticity in tension of a sheet-like resin composition, measured in accordance with ISO1184-1983). In addition, according to a sixth aspect of the present invention, there is provided the solar cell encapsulant, characterized in that, in the fourth aspect, the component (A) satisfies the following expression (a'').

$$\text{Expression (a''):} \quad -0.67 \times E + 80 \geq N \geq -0.67 \times E + 53$$

(wherein N represents the branch number per 1000 carbon atoms in a main chain and a side chain in total, measured by NMR; and E represents modulus of elasticity in tension of a sheet-like resin composition, measured in accordance with ISO1184-1983).

In addition, according to a seventh aspect of the present invention, there is provided the solar cell encapsulant, characterized in that, in any of the first to the third aspects, the component (A) has further the following characteristics (a4).

(a4) a flow ratio (FR): a ratio, ($I_{10}/I_{2.16}$), of $I_{10}$ which is an MFR measurement value at 190°C under a load of 10 kg, and $I_{2.16}$ which is an MFR measurement value at 190°C under a load of 2.16 kg, is below 7.0.

In addition, according to an eighth aspect of the present invention, there is provided the solar cell encapsulant, characterized in that, in the seventh aspect, characteristics (a4) of the component (A), the flow ratio (FR), is 5.0 to 6.2

In addition, according to a ninth aspect of the present invention, there is provided the solar cell encapsulant, characterized in that, in any of the first to the eighth aspects, the resin component is composed of the component (A) in an amount of 1% by weight or more and less than 70% by weight, and the component (B) in an amount over 30% by weight and 99% by weight or less.

In addition, according to a tenth aspect of the present invention, there is provided the solar cell encapsulant, characterized in that, in any of the first to the ninth aspects, the component (B) is one or more kinds of copolymers of ethylene-a functional group-containing monomer, selected from an ethylene-vinyl acetate copolymer, an ethylene-(meth)acrylate ester copolymer, an ethylene-(meth)acrylic acid copolymer, an ethylene-(meth)acrylate ester multi-component copolymer, and an ethylene-(meth)acrylic acid multi-component copolymer.

In addition, according to an eleventh aspect of the present invention, there is provided the solar cell encapsulant, characterized in that, in any of the first to the tenth aspects, the component (B) is an ethylene-vinyl acetate copolymer having the following characteristics (b1).

(b1) content of vinyl acetate is 20 to 40% by weight.

In addition, according to a thirteenth aspect of the present invention, there is provided the solar cell encapsulant, characterized in that, in the twelfth aspects, content of the component (C) is 0.01 to 5 parts by weight, relative to 100 parts by weight of the resin component composed of the component (A) and the component (B).

In addition, according to a fourteenth aspect of the present invention, there is provided the solar cell encapsulant, characterized in that, in any of the first to the thirteenth aspects, further the following component (D) is comprised, and content thereof is 0.2 to 5 parts by weight, relative to 100 parts by weight of the resin component composed of the component (A) and the component (B):

Component (D): an organic peroxide.

Further, according to a fifteenth aspect of the present invention, there is provided the solar cell encapsulant, characterized in that, in any of the first to the fourteenth aspects, the component (A) is an ethylene·propylene copolymer, an ethylene·1-butene copolymer or an ethylene·1-hexene copolymer.

Still more, according to a sixteenth aspect of the present invention, there is provided the solar cell encapsulant, characterized in that, in any of the first to the fourteenth aspects, the component (A) is an ethylene·propylene·1-hexene terpolymer.

On the other hand, according to a seventeenth aspect of the present invention, there is provided a solar cell module using the solar cell encapsulant according to any of the first to the sixteenth aspects.

ADVANTAGEOUS EFFECTS OF INVENTION

The solar cell encapsulant of the present invention has the resin composition, as a main component, composed of an ethylene·α-olefin copolymer having specific density, and a copolymer of ethylene-a functional group-containing monomer having specific monomer content, therefore, it has small steam transmittance and is superior in heat resistance, transparency, light transmittance, flexibility, adhesive property, durability or the like.

In addition, blending of the organic peroxide is capable of cross-linking the resin component in a relatively short period of time, in making a sheet of the resin composition, to provide sufficient adhesive strength, making easy formation of the solar cell module to provide superior productivity, and reducing production cost. In addition, when the solar cell encapsulant further blended with the silane coupling agent is used in the resin component, the obtained solar cell module becomes to have still more superior transparency, flexibility, weather resistance, adhesive property, or the like, and thus it can be expected to maintain stable conversion efficiency for a long period of time.

BRIEF DESCRIPTION OF DRAWINGS

Fig. 1 is a graph showing a range of the expression (x) specifying relation between density of component (A) and comonomer content of component (B) in the resin composition.

Fig. 2 is a graph showing a range of the expression (a) specifying relation between branch number of the resin composition (A) in the resin composition, and modulus of elasticity in tension of a sheet-like resin composition.

DESCRIPTION OF EMBODIMENTS

1. Resin composition for solar cell, encapsulant

The solar cell encapsulant of the present invention uses the resin composition for the solar cell encapsulant (hereafter may be referred to simply as the resin composition), containing the component (A) and the component (B), satisfying the following expression (x), as resin components.

$$\text{Expression (x)} \quad -480 \times [d] + 425 \leq [CM] \leq -480 \times [d] + 433$$

(wherein [d] represents density of the component (A); and [CM] represents comonomer content (mol%) of the component (B)).

(1) Component (A): the ethylene·$\alpha$-olefin copolymer

The component (A) to be used in the present invention is the ethylene·$\alpha$-olefin copolymer having the following characteristics (a1).

(a1) a density of 0.860 to 0.900 g/cm$^3$.

The component (A) to be used in the present invention is preferably the ethylene·$\alpha$-olefin copolymer having further the following characteristics (a2).

(a2) a ratio, (Mz/Mn), of Z average molecular weight (Mz) and number average molecular weight (Mn) determined by a gel permeation chromatography (GPC), is 8.0 or less.

It is more preferable that the component (A) to be used in the present invention is the ethylene·$\alpha$-olefin copolymer having further the following characteristics (a3) and/or characteristics (a4).

(a3) a branch number (N) derived from a comonomer in a polymer satisfying the following expression (a).

$$\text{Expression (a):} \quad N \geq -0.67 \times E + 53$$

(wherein N represents the branch number per 1000 carbon atoms in a main chain and a side chain in total, measured by NMR; and E represents modulus of elasticity in tension of a sheet-like resin composition, measured in accordance with ISO1184-1983).

(a4) a flow ratio (FR): a ratio, ($I_{10}/I_{2.16}$), of $I_{10}$ which is an MFR measurement value at 190°C under a load of 10 kg, and $I_{2.16}$ which is an MFR measurement value at 190°C under a load of 2.16 kg, is below 7.0.

(i) Monomer composition of component (A)

The ethylene·$\alpha$-olefin copolymer to be used in the present invention is a random copolymer of ethylene and an $\alpha$-olefin, where a composition unit derived from ethylene is a main component.
The $\alpha$-olefin to be used as the comonomer is the $\alpha$-olefin having carbon atoms of preferably 3 to 12. Specifically, it includes propylene, 1-butene, 1-pentene, 1-hexene, 1-octene, 1-heptene, 4-methyl-pentene-1, 4-methyl-1-hexene, 4,4-dimethyl-pentene-1 or the like.
A specific example of such an ethylene·$\alpha$-olefin copolymer includes an ethylene·propylene copolymer, an ethylene·1-butene copolymer, an ethylene·1-hexene copolymer, an ethylene·1-octene copolymer, an ethylene·4-methyl-pentene-1 copolymer or the like. Among these, the ethylene·1-butene copolymer and the ethylene·1-hexene copolymer are preferable.
In addition, the $\alpha$-olefin may be one kind or two or more kinds in combination. In the case of a terpolymer obtained by combining two kinds of $\alpha$-olefins, it includes an ethylene·propylene·1-hexene terpolymer, an ethylene·1-butene·1-hexene terpolymer, an ethylene·propylene·1-octene terpolymer, an ethylene·1-butene·1-octene terpolymer or the like.

As the comonomer, a diene compound such as 1, 5-hexadiene, 1,6-heptadiene, 1,7-octadiene, 1,8-nonadiene, and 1,9-decadiene may be blended in small amount to the α-olefin. Blending of these diene compounds provides long-chain branches, which decreases crystallinity and enhances transparency, flexibility, adhesive property or the like of the ethylene·α-olefin copolymer, as well as increases mechanical strength, because they also work as an inter-polymer cross-linking agent. In addition, because a terminal group of the long-chain branch is an unsaturated group, it is capable of easily generating a cross-linking reaction by the organic peroxide, or a copolymerization reaction or a graft reaction with an acid anhydride group-containing compound or an epoxy group-containing compound.

In the ethylene ·α-olefin copolymer to be used in the present invention, content of the α-olefin, which is used as a raw material monomer, is preferably 5 to 40% by weight, more preferably 10 to 35% by weight, and still more preferably 15 to 30% by weight. The content within this range provides good flexibility and heat resistance.

The content of the α-olefin here is a value measured by a 13C-NMR method under the following conditions:

Apparatus: JEOL-GSX270, manufactured by JOEL Ltd.
Concentration: 300 mg/2 mL
Solvent: Ortho-dichlorobenzene

(ii) Polymerization catalyst and Polymerization method for component (A)

The ethylene·α-olefin copolymer to be used in the present invention can be produced using a Ziegler catalyst, a vanadium catalyst or a metallocene catalyst or the like, preferably the vanadium catalyst or the metallocene catalyst, and more preferably the metallocene catalyst. A production method includes a high pressure ionic polymerization method, a vapor-phase method, a solution method, a slurry method, or the like.

The metallocene catalyst is not especially limited, however, such a catalyst is included that a metallocene compound such as a zirconium compound coordinated with a group or the like having a cyclopentadienyl skeleton, and a promoter are used as catalyst components.

Commercial products include HARMOREX (registered trademark) series and Kernel (registered trademark) series, produced by Japan Polyethylene Corp.; Evolue (registered trademark) series, produced by Prime Polymer Co., Ltd; Excellen (registered trademark) GMH series, and Excellen (registered trademark) FX series, produced by Sumitomo Chemical Co., Ltd. As the vanadium catalyst, a catalyst having a soluble vanadium compound and an organoaluminum halide as catalyst components are included.

(iii) Characteristics of component (A)

(a1) Density

The ethylene·α-olefin copolymer to be used in the present invention should be a density of preferably 0.860 to 0.900 g/cm$^3$. Preferable density is 0.865 to 0.900 g/cm$^3$, and still more preferably 0.870 to 0.900 g/cm$^3$, and still more particularly preferable one is a ultralow density ethylene·α-olefin copolymer having 0.870 to 0.885 g/cm$^3$. The density within this range provides good handling, because of being non adhesion as well as not too high rigidity of a sheet after fabrication.

In order to adjust polymer density, a method is taken for adjusting, as appropriate, for example, content of the α-olefin, polymerization temperature, catalyst amount or the like.

It should be noted that the density of the ethylene ·α-olefin copolymer is measured at 23°C in accordance with JIS-K6922-2: 1997 attachment (the case of a low density polyethylene).

In addition, density of the component (A) should satisfy the following expression (x), in relation to comonomer content of the component (B).

Expression (x) $-480 \times [d] + 425 \leq [CM] \leq -480 \times [d] + 433$ (wherein [d] represents density of the component (A) ; and [CM] represents comonomer content (mol%) of the component (B)).

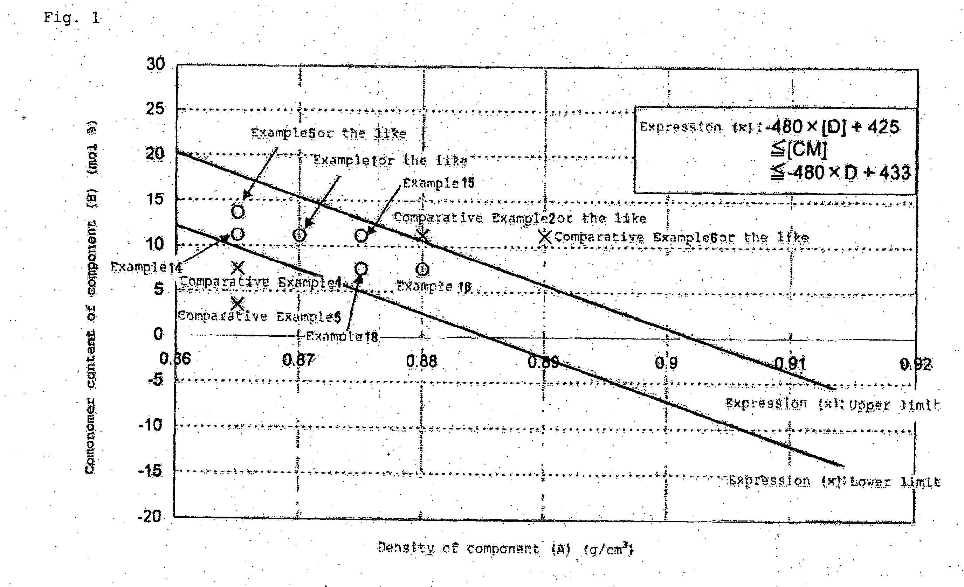

Relation between density of the component (A) and comonomer content of the resin component (B) in the resin composition is shown by a graph as the expression (x) in Fig. 1. A range of the expression (x) specified by the present invention is a range surrounded by two linear lines. The resin composition within this range (o mark) provides the solar cell encapsulant enabling to secure transparency required in the present invention, while the resin composition outside this range (× mark) cannot be used as the solar cell encapsulant, because of deterioration of transparency.

In addition, density of the component (A) in the resin composition and comonomer content of the component (B) relate to steam transmittance.

In the solar cell module, there has been prevailed the one where an upper protecting material is substituted from glass with a film, accompanying with making thinner film of the solar cell element. Because the solar cell module, where the upper protecting material is substituted with a film, is easily infiltrated by moisture from the upper protecting material side, when exposed to environment of rainy weather or high humidity, leading to corrosion of an electrode, it has been required to decrease steam transmittance of the encapsulant. In the copolymer of ethylene-a functional group-containing monomer, such as an ethylene-vinyl acetate copolymer, which has been used widely up to now, content of vinyl acetate of a comonomer, has been said preferable to be 20 to 40% by weight, and particularly preferable to be 25 to 35% by weight, however, it had a drawback of high steam transmittance. On the other hand, the ethylene·$\alpha$-olefin copolymer of the component (A) has low steam transmittance.

It is an object of the present invention to still more improve steam transmittance, without impairing transparency, by suitably combining the ethylene·$\alpha$-olefin copolymer and the copolymer of ethylene-a functional group-containing monomer. Accordingly, it is necessary for the component (A) and the component (B), which are the resin components, to satisfy the following expression(x), more preferably satisfy the following expression (x'), and still more preferably satisfy the following expression (x'').

$$\text{Expression (x')} \quad -480 \times [d] + 426 \leq [CM] \leq -480 \times [d] + 432$$

$$\text{Expression (x'')} \quad -480 \times [d] + 427 \leq [CM] \leq -480 \times [d] + 430$$

(a2) Ratio (Mz/Mn) of Z average molecular weight (Mz) and number average molecular weight (Mn).

The ethylene·$\alpha$-olefin copolymer to be used in the present invention has the ratio (Mz/Mn) of Z average molecular weight (Mz) and number average molecular weight (Mn), determined by a gel permeation chromatography (GPC), of 8.0 or less, preferably 5.0 or less, and more preferably 4.0 or less. In addition, Mz/Mn is 2.0 or more, preferably 2.5 or more, and more preferably 3.0 or more. However, the Mz/Mn over 8.0 deteriorates transparency. Adjusting of Mz/Mn within a predetermined range may be performed by a method for selecting a suitable catalyst system or the like.

It should be noted that measurement of Mz/Mn is performed by the gel permeation chromatography (GPC) under the following conditions:

Apparatus: GPC 150C model, manufactured by Waters Co., Ltd.
Detector: 1A infrared spectrophotometer (a measurement wavelength of 3.42 $\mu$m), manufactured by MIRAN Co., Ltd.
Column: Three sets of AD806M/S, manufactured by Showa Denko K.K. (Calibration of the column was performed by measurement of single dispersion polystyrene, produced by Tosoh Corp. (a 0.5 mg/ml solution of each of A500, A2500, F1, F2, F4, F10, F20, F40, and F288), and approximated logarithmic values of eluted volume and molecular weight with a quadratic expression. In addition, molecular weight of the sample was converted to that of polyethylene using viscosity equation of polystyrene and polyethylene. Here, coefficients of the viscosity equation of polystyrene are $\alpha$=0.723 and log K=-3.967, while those for polyethylene are $\alpha$=0.733 and log K=-3.407.)
Measurement temperature: 140°C
Concentration: 20 mg/10 mL
Injection volume: 0.2 mL
Solvent: Ortho-dichlorobenzene
Flow rate: 1.0 ml/minute

It should be noted that because the Z average molecular weight (Mz) has large contribution to average molecular weight of a high molecular weight component, Mz/Mn provides easy confirmation of presence of the high molecular weight component, as compared with Mw/Mn. The high molecular weight component is a factor influencing on transparency, and increase in the high molecular weight component, consequently, deteriorates transparency. In addition, tendency of deterioration of cross-linking efficiency is also observed. Smaller Mz/Mn, therefore, is preferable.

(a3) Branch number (N) derived from comonomer in polymer

In the ethylene $\alpha$-olefin copolymer to be used in the present invention, it is preferable that the branch number (N) and the modulus of elasticity in tension (E) satisfy the following expression (a).

$$\text{Expression (a): } N \geq -0.67 \times E + 53$$

(wherein N represents branch number per total 1000 carbon atoms in a main chain and a side chain, measured by NMR, and E represents modulus of elasticity in tension of a sheet, measured in accordance with ISO1184-1983).

In the present description, the branch number (N) derived from a comonomer in a polymer can be calculated from a C-NMR spectrum, with reference to, for example, E. W. Hansen, R. Blom, and O. M. Bade, Polymer, Vol. 36, p. 4295 (1997).

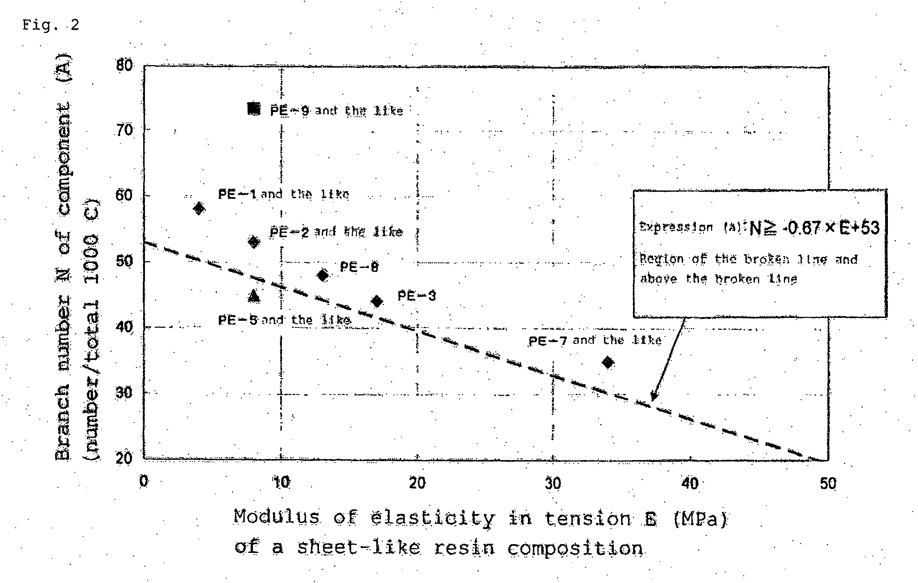

Relation between branch number of the component (A) in the resin composition, and modulus of elasticity in tension of a sheet-like resin composition is as shown by a graph in Fig. 2. A range of the expression (a) specified by the present invention is a region higher than the straight line. Inside of this range (● mark, ♦ mark) provides good balance between rigidity and cross-linking efficiency of the resin composition and thus is preferable to obtain the solar cell encapsulant of the present invention, while the region lower than this region (A mark) makes difficult to obtain the solar cell encapsulant of the present invention, because of deterioration of this balance.

In the solar cell module, there is tendency of making a thinner film of the solar cell encapsulant as well, accompanying with making thinner film of the solar cell element. In the solar cell encapsulant made as the thinner film, because of easy break of a wiring when impact is applied thereto from the upper or the lower protecting material side, it is required to increase a rigidity of the encapsulant. However, increase in the rigidity deteriorates cross-linking efficiency, therefore, it is necessary to use as a material with enhanced moldability, by using a copolymer with a certain high branch degree of a high polymer chain and thus enhancing fluidity of the copolymer before cross-linking. In the present invention, by selecting the one where the branch number (N) derived from the comonomer of the ethylene·α-olefin copolymer has a polymer structure satisfying the expression (a), balance between rigidity and cross-linking efficiency can be made good.

The ethylene·α-olefin copolymer relevant to the present invention can be produced by a copolymerization reaction using a catalyst, as described above, however, by selecting composition ratio of raw material monomers to be copolymerized, or kind of the catalyst, branch degree in the high polymer chain can easily be adjusted. For the ethylene·α-olefin copolymer to be used in the present invention to satisfy the expression (a), the comonomer in the ethylene·α-olefin copolymer is preferably selected from propylene, 1-butene or 1-hexene. In addition, it is preferable to produce it using a vapor phase method and a high pressure method, and in particular, it is more preferable to select the high pressure method.

More specifically, increasing or decreasing N by fixing E can be attained by a method for changing mainly number of carbon atoms of a comonomer to be copolymerized with ethylene. It is preferable to produce the ethylene·α-olefin copolymer by mixing 1-butene or 1-hexene so as to become an amount of 60 to 80% by weight, relative to ethylene, using a metallocene catalyst, and reacting them at a polymerization temperature of 130 to 200°C. In this way, the branch number N of the ethylene·α-olefin copolymer can be adjusted suitably, and the ethylene·α-olefin copolymer can be obtained, which has a modulus of elasticity in tension E of the obtained sheet of 40 MPa or less, and within a range shown by the expression (a).

In the present invention, it is preferable that a relational expression of characteristics (a3) is shown by the following expression (a'). In addition, it is more preferable that a relational expression of characteristics (a3) is the following expression (a''), and particularly preferable to be the following expression (a'''). Satisfaction of these conditions provides still more good balance between rigidity and cross-linking efficiency of the resin composition

$$\text{Expression (a'): } -0.67 \times E + 100 \geq N \geq -0.67 \times E + 53$$

$$\text{Expression (a''): } -0.67 \times E + 80 \geq N \geq -0.67 \times E + 53$$

$$\text{Expression (a'''): } -0.67 \times E + 75 \geq N \geq -0.67 \times E + 54$$

(a4) Flow ratio (FR)

The ethylene·α-olefin copolymer to be used in the present invention preferably has the flow ratio (FR), that is, the ratio ($I_{10}/I_{2.16}$) of $I_{10}$ which is an MFR measured value at 190°C under a load of 10 kg, and $I_{2.16}$ which is an MFR measured value at 190°C under a load of 2.16 kg, of below 7.0. It should be noted that melt flow ratio (MFR) is a value measured in accordance with JIS-K7210-1999.

It has been known that FR has close relationship with molecular weight distribution and amount of a long chain branch of the ethylene·α-olefin copolymer. In the present invention, among polymers satisfying the above requisite (a1), such one is used that has the ratio ($I_{10}/I_{2.16}$) of an MFR measured value ($I_{10}$) at 190°C under a load of 10 kg, and an MFR measured value ($I_{2.16}$) at 190°C under a load of 2.16 kg of below 7.0. Use of a copolymer having a polymer structure characterized in such a long chain branch provides good balance rigidity and cross-linking efficiency. On the other hand, the FR of 7.0 or more tends to deteriorate cross-linking efficiency in cross-linking as the solar cell encapsulant.

The FR of the ethylene·$\alpha$-olefin copolymer to be used in the present invention is below 7.0, preferably below 6.5, and more preferably below 6.3. It should be noted that FR below 5.0 has difficulty in obtaining sufficient rigidity as the solar cell encapsulant. The flow ratio (FR) of characteristics (a6) is most preferably 5.0 to 6.2

(2) Component (B): Copolymer of ethylene-a functional group-containing monomer

The component (B) to be used in the present invention is the copolymer of ethylene-a functional group-containing monomer, to be described below in detail.

The copolymer of ethylene-a functional group-containing monomer to be used in the present invention is a random copolymer of ethylene-a functional group-containing monomer, having a composition unit derived from ethylene, as a main component.

As a specific example of such a copolymer of ethylene-a functional group-containing monomer, there is included an ethylene-vinyl acetate copolymer, an ethylene-(meth)acrylate ester copolymer, an ethylene-(meth)acrylic acid copolymer, an ethylene-(meth)acrylate ester multi-component copolymer, an ethylene-(meth)acrylic acid multi-component copolymer, or the like, and one kind or two or more kinds by mixing thereof may be used.

It is preferable that the component (B) is an ethylene-vinyl acetate copolymer. Content of vinyl acetate in an ethylene-vinyl acetate copolymer is preferably 20 to 40% by weight, and particularly preferably 25 to 35% by weight. The vinyl acetate content within this range has effect for enhancing transparency. In addition, melt flow rate (MFR) is measured, in accordance with JIS-K6922-2: 1997 attachment (at 190°C and a load of 21.18 N), and it is preferably 5 to 50 g/10 minutes, more preferably 10 to 40 g/10 minutes, and particularly preferably 15 to 30 g/10 minutes. The component (B) having melt flow rate (MFR) within this range can be mixed well with the component (A), which still more enhances the above effect.

A commercial product of the ethylene-vinyl acetate copolymer includes trade names: LV670 and LV780, produced by Japan Polyethylene Corporation.

(3) Blending ratio of component (A) and component (B)

In the present invention, blending ratio of the component (A) and the component (B) is not especially limited, as long as the object of the present invention can be attained. Blending of the resin components so as to attain the component (B) over 30% by weight and 99% by weight or less, relative to 1% by weight or more and less than 70% by weight of the component (A), is capable of suppressing steam transmittance of the resin composition to a low level. And, preferable blending ratio is 95 to 40% by weight of the component (B), relative to 5 to 60% by weight of the component (A), more preferably, 90 to 50% by weight of the component (B), relative to 10 to 50% by weight of the component (A), and still more preferably, 80 to 60% by weight of the component (B), relative to 20 to 40% by weight of the component (A). The blending ratio within this range is capable of suppressing steam transmittance still more.

It should be noted that other resin components can be contained other than the component (A) and the component (B), within a range not to impair effect, such as transparency or the like, of the present invention.

(4) Component (C): Silane coupling agent

The silane coupling agent is used in the resin composition of the present invention to improve adhesion property between the resin composition and a glass substrate.

The silane coupling agent includes unsaturated silane compounds which are vinylsilanes such as vinyltrimethoxysilane, vinyltriethoxysilane, vinyltriacetylsilane, vinyltrichlorosilane, vinyltriisopropoxysilane, vinyltrismethylethylketoxime silane, vinyltriisopropenoxysilane, vinylmethyldimethoxysilane, vinyldimethylmethoxysilane; acrylsilanes such as acryloxymethyltrimethoxysilane, acryloxymethyltriethoxysilane, acryloxymethylmethyldimethoxysilane, acryloxymethyldimethylmethoxysilane, $\gamma$-acryloxypropyltrimethoxysilane, $\gamma$-acryloxypropyltriethoxysilane, $\gamma$-acryloxypropylmethyldimethoxysilane, $\gamma$-acryloxypropylmethyldiethoxysilan, $\gamma$-acryloxypropyldimethylmethoxysilane; methacrylsilanes such as methacryloxymethyltrimethoxysilane, methacryloxymethyltriethoxysilane, methacryloxymethylmethyldimethoxysilane, methacryloxymethyldimethylmethoxysilane, $\gamma$-methacryloxypropyltrimethoxysilane, $\gamma$-methacryloxypropyltriethoxysilane, $\gamma$-methacryloxypropylmethyldimethoxysilane, $\gamma$-methacryloxypropylmethyldiethoxysilane, $\gamma$-methacryloxypropyldimethylmethoxysilane; and styrylsilanes such as styryltrimethoxysilane, styryltriethoxysilane, styrylmethyldimethoxysilane, N-vinylbenzyl-$\gamma$-aminopropyltrimethoxysilane, N-vinylbenzyl-$\gamma$-aminopropylmethyldimethoxysilane. It should be noted that these silane coupling agents can be used alone or by mixing two or more kinds.

These silane coupling agents can be blended in an amount of up to 5 parts by weight, when total amount of the component (A) and the component (B) is 100 parts by weight. It is used in blending amount of preferably 0.01 to 5 parts by weight, more preferably 0.01 to 2 parts by weight, still more preferably 0.05 to 1 part by weight.

(5) Component (D): Organic peroxide

The organic peroxide is used in the resin composition of the present invention, in order to cross-link the resin component composed of the component (A) and the component (B).

As the organic peroxide, the organic peroxide having a decomposition temperature (temperature where half-life period is 1 hour) of 70 to 180°C, in particular, 90 to 160°C may be used. As such organic peroxide, there is included, for example, t-butylperoxy isopropyl carbonate, t-butylperoxy-2-ethylhexyl carbonate, t-butyl peroxyacetate, t-butyl peroxybenzoate, dicumyl peroxide, 2,5-dimethy-2,5-di(t-butylperoxy)hexane, di-t-butyl peroxide, 2,5-dimethy-2,5-di(t-butylperoxy)hexyne-3, 1,1-di-(t-butylperoxy)-3,3,5-trimethylcyclohexane, 1, 1-di (t-butylperoxy) cyclohexane, methyl ethyl ketone peroxide, 2,5-dimethyhexyl-2,5-diperoxybenzoate, t-butyl hydroperoxide, p-menthane hydroperoxide, benzoyl peroxide, p-chlorbenzoyl peroxide, t-butyl peroxyisobutyrate, hydroxyheptyl peroxide, cyclohexanone peroxide.

In the present invention, the blending ratio of the component (D) is up to 5 parts by weight, preferably 0.2 to 5 parts by weight, more preferably 0.5 to 3 parts by weight, and still more preferably 1 to 2 parts by weight, when total amount of the component (A) and the component (B) is 100 parts by weight. Non-blending of the component (D), or the blending ratio of the component (D) lower than the above range does not provide cross-linking or tends to take longer time in cross-linking, while the ratio higher than the above range provides insufficient dispersion and tends to provide a non-uniform cross-linking degree

(6) Component (E): Hindered amine-type light stabilizer

In the present invention, it is preferable to blend the hindered amine-type light stabilizer to the resin composition, as the component (E). The hindered amine-type light stabilizer is the one which captures radical species hazardous to a polymer and inhibits generation of new radicals. As the hindered amine-type light stabilizer, there are many kinds of compounds from a low molecular weight-type to a high molecular weight-type, and a conventionally known one can be used without any special limitation.

As the low molecular weight-type hindered amine-type light stabilizer, there is included the one composed of 70% by weight of a reaction product of bis(2,2,6,6-tetramethyl-1-(octyloxy)-4- piperidinyl) decanedioate (molecular weight: 737), 1,1-dimethyethyl hydroperoxide, and octane and 30% by weight of polypropylene; bis (1,2,2,6,6-pentamethyl-4-piperidyl) 3,5-bis(1,1-dimethyethyl)-4-hydroxyphenyl]methyl]butyl malonate (molecular weight: 685); a mixture of bis(1,2,2,6,6-pentamethyl-4-piperidyl)sebacate and methyl 1,2,2,6,6-pentamethyl-4-piperidyl sebacate(molecular weight: 509); bis(2,2,6,6-tetramethyl-4-piperidyl) sebacate (molecular weight: 481); tetrakis(2,2,6,6-tetramethyl-4-piperidyl)-1,2,3,4-butane tetracarboxylate (molecular weight: 791); tetrakis(1,2,2,6,6-pentamethyl-4-piperidyl)-1,2,3,4-butane tetracarboxylate (molecular weight: 847); a mixture of 2,2,6,6-tetramethyl-4-piperidyl- 1,2,3,4-butanetetracarboxylate and tridecyl-1,2,3,4-butane tetracarboxylate (molecular weight: 900); a mixture of 1,2,2,6,6-pentamethyl-4-piperidyl-1,2,3,4-butane tetracarboxylate and tridecyl-1, 2, 3, 4-butane tetracarboxylate (molecular weight: 900) or the like.

As the high molecular weight-type hindered amine-type light stabilizer, there is included poly[{6-(1,1,3,3-tetramethylbutyl)amino-1,3,5-triazine-2,4-diyl}{(2,2,6,6-te   tramethyl-4-piperidyl)imino}hexamethylene{ (2,2,6,6-tetramet hyl-4-piperidyl)imino}] (molecular weight: 2,000-3,100); a polymerization product of dimethyl succinate and 4-hydroxy-2,2,6,6-tetramethyl-1-piperidine ethanol (molecular weight: 3100-4000); a mixture of N,N',N'',N'''-tetrakis-(4,6-bis-(butyl-(N-methyl-2,2,6,6-tetramethylpiperidine-4-yl)amino)-triazine-2-yl)-4,7-diazadecane-1,10-diamine (molecular weight: 2286) and the above-described polymerization product between dimethyl succinate and 4-hydroxy-2,2,6,6-tetramethyl-1-piperidine ethanol; a polycondensate (molecular weight: 2600-3400) of dibutylamine-1,3,5-triazine-N,N'-bis(2,2,6,6-tetramethyl-4-piperidyl-1,6-hexamethylene diamine and N-(2,2,6,6-tetramethyl-4-piperidyl)butylamine, and a copolymer of a cyclic aminovinyl compound such as 4-acryloyloxy-2,2,6,6-tetramethylpiperidine, 4-acryloyloxy-1,2,2,6,6-pentamethylpiperidine, 4-acryloyloxy-1-ethyl-2,2,6,6-tetramethylpiperidine, 4-acryloyloxy-1-propyl-2,2,6,6-tetramethylpiperidine, 4-acryloyloxy-1-butyl-2,2,6,6-tetramethylpiperidine, 4-methacryloyoxy-2,2,6,6-tetramethylpiperidine, 4-methacryloyoxy-1,2,2,6,6-pentamethylpiperidine, 4-methacryloyoxy-1-ethyl-2,2,6,6-tetramethylpiperidine, 4-methacryloyoxy-1-butyl-2,2,6,6-tetramethylpiperidine, 4-crotonoyloxy-2,2,6,6-tetramethylpiperidine, 4-crotonoyloxy-1-propyl-2,2,6,6-tetramethylpiperidine, and ethylene(ethylene·cyclic aminovinyl compound copolymer) (molecular weight: 1200 or higher); and the like. The above hindered amine-type light stabilizers may be used alone or by mixing two or more kinds.

Among these, as the hindered amine-type light stabilizer, it is preferable poly[{6-(1,1,3,3-tetramethylbutyl) amino-1,3,5-triazine-2,4-diyl}{(2,2,6,6-tetramethyl-4-piper idyl)imino}hexamethylene{ (2,2,6,6-tetramethyl-4-piperidyl)i mino}] (molecular weight: 2,000-3,100); a polymerization product (molecular weight: 3100-4000) of dimethy succinate and 4-hydroxy-2,2,6,6-tetramethyl-1-piperidine ethanol; a mixture of N,N',N'',N'''-tetrakis-(4,6-bis(butyl-(N-methyl-2,2,6,6-tetramethylpiperidine-4-yl)amino)-triazine-2-yl)-4,7-diazad ecane-1,10-diamine (molecular weight: 2286) and the above polymerization product of dimethyl succinate and 4-hydroxy-2,2,6,6-tetramethyl-1-piperidine ethanol; a polycondensate (molecular weight: 2,600-3,400) of dibutylamine-1,3,5-triazine-N,N'-bis(2,2,6,6-tetramethyl-4-piperidyl-1,6-hexamethylene diamine and N-(2,2,6,6-tetramethyl-4-piperidyl)butylamine; a copolymer of a cyclic aminovinyl compound and ethylene(ethylene·cyclic aminovinyl compound copolymer).

Bleeding out of with time of the hindered amine-type light stabilizer can be prevented in use of a product, by using these. In addition, it is preferable to use the hindered amine-type light stabilizer having a melting point of 60°C or higher, in view of easiness in producing the composition.

In the present invention, content of the hindered amine-type light stabilizer is 0 to 2.5 parts by weight, when the total amount of the component (A) and the component (B) is 100 parts by weight. It is set at preferably 0.01 to 2.5 parts by weight, more preferably 0.01 to 1.0 part by weight, still more preferably 0.01 to 0.5 parts by weight, and particularly preferably 0.01 to 0.2 parts by weight, and most preferably 0. 03 to 0.1 parts by weight,.

By setting the above content at 0.01 parts by weight or more, sufficient stabilization effect can be obtained, while by setting it at 2.5 parts by weight or less, discoloration of a resin caused by excess addition of the hindered amine-type light stabilizer can be suppressed.

In addition, weight ratio (D:E) of the above organic peroxide (D) and the above hindered amine light stabilizer (E) is preferably 1:0.01 to 1:10, and more preferably 1:0.02 to 1:6.5. In this way, yellowing of a resin can be suppressed significantly.

(7) Cross-linking auxiliary agent

In addition, the cross-linking auxiliary agent may be blended into the resin composition of the present invention. The cross-linking auxiliary agent promotes a cross-linking reaction and is effective to enhance cross-linking degree of the ethylene·$\alpha$-olefin copolymer or the copolymer of ethylene-a functional group-containing monomer and as a specific example thereof, a poly-unsaturated compound such as a polyallyl compound and a poly(meth)acryloyloxy compound can be exemplified.

More specifically, there may be included a polyallyl compound such as triallyl isocyanurate, triallyl cyanurate, diallyl phthalate, diallyl fumarate, or diallyl maleate; a poly (meth) acryloxy compound such as ethylene glycol diacrylate, ethylene glycol dimethacrylate, or trimethylolpropane trimethacrylate; and divinylbenzene; or the like. The cross-linking auxiliary agent may be blended in a ratio of about 0 to 5 parts by weight, relative to 100 parts by weight of the component (A).

(8) Ultraviolet absorbing agent

The ultraviolet absorbing agent may be blended into the resin composition of the present invention. As the ultraviolet absorbing agent, various types such as benzophenone-type, benzotriazole-type, triazine-type, and salicylate ester-type may be included. Among these, use of the benzophenone-type ultraviolet absorbing agent is preferable.

The benzophenone-type ultraviolet absorbing agent may include, for example, 2-hydroxy-4-methoxybenzophenone, 2-hydroxy-4-methoxy-2'-carboxybenzophenone, 2-hydroxy-4-n-octoxybenzophenone, 2-hydroxy-4-n-dodecyloxybenzophenone, 2-hydroxy-4-n-octadecyloxybenzophenone, 2-hydroxy-4-benzyloxybenzophenone, 2-hydroxy-4-methoxy-5-sulfobenzophenone, 2-hydroxy-5-chlorobenzophenone, 2,4-dihydroxybenzophenone, 2,2'-dihydroxy-4-methoxybenzophenone, 2,2'-dihydroxy-4,4'-dimethoxybenzophenone, or 2,2',4,4'-tetrahydroxybenzophenone, or the like.

The benzotriazole-type ultraviolet absorbing agent is a hydroxyphenyl substituted benzotriazole compound, may include, for example, 2-(2-hydroxy-5-methylphenyl)benzotriazole, 2-(2-hydroxy-5-t-butylphenyl)benzotriazole, 2-(2-hydroxy-3,5-dimethylphenyl)benzotriazole, 2-(2-methyl-4-hydroxyphenyl)benzotriazole, 2-(2-hydroxy-3-methyl-5-t-butylphenyl)benzotriazole, 2-(2-hydroxy-3,5-di-t-amylphenyl)benzotriazole, 2-(2-hydroxy-3,5-di-t-butylphenyl)benzotriazole or the like. In addition, the triazine type ultraviolet absorber includes, 2-[4,6-bis(2,4-dimethyphenyl)-1,3,5-triazine-2-yl]-5-(octyl oxy)phenol, 2-(4,6-diphenyl-1,3,5-triazine-2-yl)-5-(hexyloxy)phenol or the like. The salicylic acid ester type includes phenyl salicylate, p-octylphenyl salicylate or the like.

In addition, as the triazine type ultraviolet absorbing agent, there is included 2-[4,6-bis(2,4-dimethylphenyl)-1,3,5-triazine-2-yl]-5-(octy loxy)phenol, 2-(4,6-diphenyl-1,3,5-triazine-2-yl)-5-(hexyloxy)phenol, or the like. Salicylic acid ester type can include phenyl salicylate, p-octylphenyl salicylate, or the like.

These ultraviolet absorbing agents are blended in an amount of 0 to 2.0 parts by weight, preferably 0.05 to 2.0 parts by weight, more preferably 0.1 to 1.0 part by weight, still more preferably 0.1 to 0.5 parts by weight, and most preferably 0.2 to 0.4 parts by weight, when total amount of the component (A) and the component (B) is 100 parts by weight.

(9) Other additive components

Other additive arbitrary components can be blended in this resin composition to be used in the present invention within a range not to impair objectives of the present invention. Such an arbitrary additive component includes an antioxidant, a crystallization nucleating agent, a transparency enhancing agent, a lubricant, a coloring agent, a dispersing agent, a filler, a fluorescent whitening agent, a ultraviolet absorbing agent and a light stabilizer, which are used in a usual polyolefin-type resin material, or the like.

In addition, a rubber-type compound such as a crystalline ethylene·$\alpha$-olefin copolymer obtained by polymerization using a Ziegler-type or a metallocene-type catalyst; and/or ethylene·$\alpha$-olefin elastomer such as EBR or EPR; or styrene-type elastomer such as SEBS, a hydrogenated styrene block copolymer or the like may also be blended in 3 to 75 parts by weight, relative to 100 parts by weight of the above resin composition, in order to provide flexibility or the like, within a range not to impair objectives of the present invention. Still more, in order to provide melt tension or the like, low density polyethylene produced by a high pressure method can be blended in 3 to 75 parts by weight as well.

2. Production of solar cell encapsulant

The solar cell encapsulant (hereinafter may be referred to simply as the encapsulant) of the present invention is prepared using the above resin component. The solar cell encapsulant is used by a sheet-like form with a thickness of usually about 0.1 to 1 mm. The thickness less than 0.1 mm provides weak strength and insufficient adhesion, while the thickness more than 1 mm may raise a problem caused by decreased transparency. Preferable thickness is 0.1 to 0.8 mm.

A sheet-like solar cell encapsulant can be produced by a known sheet molding method, using a T-die extruder, a calendering machine or the like. It can be obtained by dry blending the additives such as a silane coupling agent, the organic peroxide (cross-linking agent), and a hindered amine-type light stabilizer, an ultraviolet absorbing agent, a cross-linking auxiliary agent and an antioxidant, as needed, in advance, to the resin component composed of the ethylene·$\alpha$-olefin copolymer and the copolymer of ethylene-a functional group-containing monomer, and by supplying them from a hopper of the T-die extruder, and by performing extrusion molding into a sheet-like form. Off course, in this dry blending, a part of or all of the additives can be used in a form of a master batch. In addition, such a resin composition may also be used that is obtained by blending a part of or all of the additives such as the organic peroxide (cross-linking agent), to the resin component composed of the ethylene·$\alpha$-olefin copolymer and the copolymer of ethylene-a functional group-containing monomer, in advance, in T-die extrusion or calendering, and by melt mixing using a single-screw extruder, a twin-screw extruder, a Banbury mixer and a kneader, or the like.

Production of a sheet using the above resin composition provides small steam transmittance of the sheet as well as good haze, steam transmittance, heat resistance, adhesive property to glass. In particular, steam transmittance becomes superior such as 17 g/($m^2$·24h) or lower. In addition, in the case of a pressed sheet having a thickness of 0.7 mm, cross-linked at 150°C for 30 minutes, in accordance with JIS-K7136-2000, there may be the one having a haze of 3.0 or lower, that is, superior transparency. Haze is preferably 2.0 or lower.

3. Solar cell module

The solar cell module can be produced by using the solar cell encapsulant of the present invention, encapsulating a solar cell element, and still more fixing with protecting materials.

As such a solar cell module, various types can be exemplified. For example, there may be exemplified the one having a composition where the solar cell element is sandwiched from both sides thereof with the encapsulant, such as the upper transparent protecting material/the encapsulant/the solar cell element/the encapsulant/the lower protecting material; the one having a composition where the encapsulant and the upper transparent protecting material are formed on the solar cell element formed on the inner circumference plane of the lower substrate protecting material; the one having a composition where the encapsulant and the lower protecting material are formed under the solar cell element (for example, the one where an amorphous solar cell element is prepared by sputtering or the like on a fluorocarbon resin-type transparent protecting material) formed on the inner circumference plane of the upper transparent protecting material; or the like.

The solar cell element is not especially limited, and various types of solar cell elements such as a silicon-type such as monocrystalline silicon, polycrystalline silicon or amorphous silicon; a III-V group and II-VI group compound semiconductor type of gallium-arsenic, copper-indium-selenium, cadmium-tellurium or the like, can be used.

As the upper protecting material composing the solar cell module, glass, acrylic resin, polycarbonate, polyester and fluorine-containing resin, or the like can be exemplified. The lower protecting material is a single or multi-layer sheet of a metal or various thermoplastic resin films and the like, for example, there can be exemplified a single layer or multi-layer protecting film of a metal including tin, aluminum, stainless steel, an inorganic material such as glass, polyester, polyester vapor-deposited with an inorganic substance, a fluorine-containing resin or a polyolefin or the like. To such an upper and/or lower protecting material, primer treatment can be performed to enhance adhesion property with the encapsulant. The resin composition in the present invention is applicable to a flexible protecting material, due to flexibility, and in the case of containing the silane coupling agent, use of glass is preferable as the upper protecting material.

In producing the solar cell module, a module having the aforesaid composition can be formed by a method for preparing a sheet of the encapsulant of the present invention, in advance, and press-adhering it at temperature for melting the encapsulant. In addition, by adopting a method for laminating the solar cell element or the upper protecting material or the lower protecting material, by extrusion coating of the encapsulant of the present invention, the solar cell module can be produced in one stage without sheet molding separately. Use of the encapsulant of the present invention, consequently, is capable of improving productivity of the module significantly.

In the present invention, in the case where the organic peroxide (cross-linking agent) is blended to the encapsulant, firstly said encapsulant may be adhered tentatively to the solar cell element or the protecting material at such temperature that the organic peroxide does not substantially decompose and the encapsulant of the present invention melts, and then by raising temperature sufficient adhesion and cross-linking of the composition composed of the ethylene·$\alpha$-olefin copolymer and the copolymer of ethylene-a functional group-containing monomer, may be performed.

EXAMPLES

Explanation will be given below specifically on the present invention with reference to Examples, however, the present invention should not be limited to these Examples. It should be noted that evaluation methods and resins used in Examples and Comparative Examples are as follows.

1. Evaluation methods for resin properties

(1) Melt flow rate (MFR): MFR of the ethylene-$\alpha$-olefin copolymer and the copolymer of ethylene and the functional group-containing monomer was measured in accordance with JIS-K6922-2: 1997 attachment (at 190°C, under a load of 21.18 N).

(2) Density: Density of the ethylene·$\alpha$-olefin copolymer was measured in accordance with JIS-K6922-2: 1997 attachment (at 23°C, the case of a low density polyethylene), as described above.

(3) Mz/Mn: It was measured by GPC, as described above.

(4) Branch number: Branch number (N) in a polymer was measured by NMR under the following conditions, and comonomer amount was determined as number per total 1000 carbons of a main chain and a side chain.

Apparatus: AVANCE III cryo-400MHz, manufactured by Bruker BioSpin K. K.

Solvent: Ortho-dichlorobenzene/deuterated bromobenzene=8/2 mixed solution

<Amount of a sample>

460 mg/2.3 ml

<C-NMR>

* H-decoupling and NOE present
* Cumulative number: 256 scans
* Flip angle: 90 degree
* Pulse interval: 20 seconds
* AQ (incorporation time): 5.45 s, D1 (waiting time)=14.55 s (5) FR: Ratio ($I_{10}/I_{2.16}$) of an MFR measured value ($I_{10}$) at 190°C under a load of 10 kg, and an MFR measured value ($I_{2.16}$) at 190°C under a load of 2.16 kg was calculated, in accordance with JIS-K7210-1999, to be used as FR.

2. Evaluation methods for sheet

(1) Haze

It was measured using a pressed sheet with a thickness of 0.7 mm, in accordance with JIS-K7136-2000. The pressed sheet was set in a glass cell filled with special grade liquid paraffin, produced by Kanto Chemical Co., Inc., to measure haze. The pressed sheet was prepared by storing it in a hot press machine under a temperature condition of 150°C for 30 minutes for cross-linking. The smaller HAZE value shows the better performance.

(2) Light transmittance

It was measured using a pressed sheet with a thickness of 0.7 mm, in accordance with JIS-K7136-1997. The pressed sheet was set in a glass cell filled with special grade liquid paraffin, produced by Kanto Chemical Co., Inc., to measure light transmittance. The pressed sheet was prepared by storing it in a hot press machine under a temperature condition of 150°C for 30 minutes for cross-linking.
Light transmittance is 80% or more, preferably 85% or more, and still preferably 90% or more.

(3) Modulus of elasticity in tension

Modulus of elasticity in tension was measured using a pressed sheet with a thickness of 0.7 mm, in accordance with IS01184-1983. It should be noted that modulus of elasticity in tension was determined at an elongation rate of 1%, under conditions of an elongation speed of 1 mm/min, a test piece width of 10 mm, and a distance between grippers of 100 mm. The smaller value shows the more superior flexibility.

(4) Heat resistance

It was evaluated by gel fraction of a sheet cross-linked at 160°C for 30 minutes and a sheet cross-linked at 150°C for 30 minutes. The higher gel fraction shows more progress of cross-linking and is evaluated as having higher heat resistance. The one with the gel fraction of 70% by weight or more was ranked "o" in evaluation of heat resistance, the one with 60 to 69% by weight was ranked "Δ", and the one with below 60% by weight was ranked "×".
It should be noted that the gel fraction is calculated by accurately weighing about 1 g of the relevant sheet, immersing it in 100 cc of xylene, treating it at 110°C for 24 hours, drying the residue after filtration, accurately weighing, and dividing it with weight before the treatment.

(5) Adhesion property with glass

A slide glass with a size of 7.6 cmx2. 6 cm and a thickness of 1 mm was used. The resin composition was contacted with the slide glass, and performed heating under a condition of 150°C for 30 minutes, using a press machine. Evaluation was performed after standing it in atmosphere of 23°C for 24 hours, and ranked [x] when the resin was peeled from the slide glass by hands, and [○] when it was not peeled.

(6) Steam transmittance

Steam transmittance $(g/(m^2 \cdot 24hr))$ was measured using a sheet with a thickness of 0.7 mm, crosslinked at 150°C for 30 minutes, in accordance with a moisture sensitivity sensor method of JIS-K7129-2008, attachment A. As for steam transmittance of sheet, smaller is more preferable.

4. Raw materials used

(1) Ethylene ·α-olefin copolymer

The following copolymers were used: copolymers of ethylene and 1-hexene polymerized in <Production Examples 1 to 3> <Production Examples 5, 6> (PE-1 to 3) (PE-7, 8); a copolymer of ethylene and 1-butene polymerized in <Production Example 4> (PE-4); commercial copolymers of ethylene and 1-octene (PE-5: ENGAGE8200, produced by Dow Chemical Co., Ltd.), (PE-6: ENGAGE8400, produced by Dow Chemical Co., Ltd.); and a terpolymer of ethylene, propylene and 1-hexene polymerized in the <Production Example 7> (PE-9). Characteristics thereof are shown in Table 1 and Fig. 2.

(2) Component (B): Ethylene-vinyl acetate copolymer

The ethylene-vinyl acetate copolymers (EVA-1 to EVA-4) obtained by a high pressure radical polymerization method were used. Characteristics thereof are shown in Table 1.

(3) Organic peroxide:

2,5-dimethyl-2,5-di(t-butylperoxy)hexane (Luperox 101, produced by Arkema-Yoshitomi Co. Ltd.)

(4) Silane coupling agent:

γ-methacryloxypropyltrimethoxysilane (KBM503, produced by Shin-Etsu Chemical Co., Ltd.)

(5) Hindered amine-type light stabilizer: a polymerization product of dimethyl succinate and 4-hydroxy-2,2,6,6-tetramethyl-1-piperidine ethanol (TINUVIN 622LD, produced by BASF AG.)

(6) Ultraviolet absorbing agent:

2 -hydroxy-4-n-octoxybenzophenone (CYTEC UV531, produced by Sun Chemical Co. Ltd.)

<Production Example 1>

(i) Preparation of catalyst

A catalyst was prepared by a method described in JP-A-7-508545. That is, to 2.0 mmol of a complex of dimethylsilylenebis(4,5,6,7-tetrahydroindenyl)hafnium dimethyl, equimolar amount of tripentafluorophenylboron, based on the above complex, was added, and by dilution with toluene to 10 L, a catalyst solution was prepared.

(ii) Polymerization

Using a stirring-type autoclave-type continuous reactor with an inner volume of 1.5 L, a mixture of ethylene and 1-hexene, as a raw material gas, was continuously supplied in a rate of 40 kg/hr, so that the composition of 1-hexene was 75% by weight, under maintaining pressure inside the reactor at 130 MPa. In addition, the above catalyst solution was supplied continuously by adjusting supply amount thereof so as to maintain polymerization temperature at 105°C. Production amount of the polymer was about 1.8 kg per hour. After completion of the reaction, the ethylene·1-hexene copolymer (PE-1), with a content of 1-hexene of 32% by weight, an MFR of 1.0 g/10 min, a density of 0.865 g/cm$^3$, and a Mz/Mn of 3.7, was obtained.

In addition, after preheating the PE-1 at 160°C-0 kg/cm$^2$ for 3 minutes, it was pressurized at 160°C-100 kg/cm$^2$ for 5 minutes, and then by cooling it with a cooling press set at 30°C, under a condition of 100 kg/cm$^2$ for 10 minutes, a pressed sheet with a thickness of 0.7 mm was obtained. As a result of performing measurement of modulus of elasticity in tension thereof, in accordance with IS01184-1983, it was 4 MPa.

Characteristics of this ethylene·1-hexene copolymer (PE-1) are shown in Table 1.

<Production Example 2>

Polymerization was performed by a similar method as in Production Example 1, except that composition of 1-hexene in polymerization was changed to 77% by weight and polymerization temperature was changed to 124°C in Production Example 1. Production amount of the polymer was about 3.2 kg per hour. After completion of the reaction, the ethylene·1-hexene copolymer (PE-2), with content of 1-hexene=29.5% by weight, MFR=5.0 g/10 min, density=0.870 g/cm$^3$, and Mz/Mn=3.5, was obtained. As a result of performing measurement of modulus of elasticity in tension thereof, similarly as in Production Example 1, it was found to be 8 MPa. Characteristics of this ethylene·1-hexene copolymer (PE-2) are shown in Table 1.

<Production Example 3>

Polymerization was performed by a similar method as in Production Example 1, except that composition of 1-hexene in polymerization was changed to 75% by weight and polymerization temperature was changed to 150°C in Production Example 1. Production amount of the polymer was about 4.3 kg per hour. After completion of the reaction, the ethylene·1-hexene copolymer (PE-3), with content of 1-hexene=24.0% by weight, MFR=35 g/10 min, density=0.880 g/cm$^3$, and Mz/Mn=3.7, was obtained. As a result of performing measurement of modulus of elasticity in tension thereof, similarly as in Production Example 1, it was found to be 17 MPa. Characteristics of this ethylene·1-hexene copolymer (PE-3) are shown in Table 1.

<Production Example 4>

Polymerization was performed by changing monomer composition and polymerization temperature in polymerization in Production Example 1, so as to attain composition and density shown in Table 1. After completion of the reaction, the ethylene·1-butene copolymer (PE-4), with content of 1-butene=35% by weight, MFR=33 g/10 min, density=0.870 g/cm$^3$, and Mz/Mn=3.5, was obtained. As a result of performing measurement of modulus of elasticity in tension thereof, similarly as in Production Example 1, it was found to be 8 MPa. Characteristics of this ethylene·1-butene copolymer (PE-4) are shown in Table 1.

<Production Example 5>

Polymerization was performed by a similar method as in Production Example 1, except that composition of 1-hexene in polymerization was changed to 71% by weight and polymerization temperature was changed to 157°C in Production Example 1. Production amount of the polymer was about 4.0 kg per hour. After completion of the reaction, the ethylene·1-hexene copolymer (PE-7), with content of 1-hexene=19% by weight, MFR=30 g/10 min, density=0.890 g/cm$^3$, and Mz/Mn=3.7, was obtained. As a result of performing measurement of modulus of elasticity in tension thereof, similarly as in Production Example 1, it was found to be 34 MPa. Characteristics of this ethylene·1-hexene copolymer (PE-4) are shown in Table 1.

Polymerization was performed by a similar method as in Production Example 1, except that composition of 1-hexene in polymerization was changed to 76% by weight and polymerization temperature was changed to 146°C in Production Example 1. Production amount of the polymer was about 4.3 kg per hour. After completion of the reaction, the ethylene·1-hexene copolymer (PE-8), with content of 1-hexene=26.0% by weight, MFR=30 g/10 min, density=0.875 g/cm$^3$, and Mz/Mn=3.7, was obtained. As a result of performing measurement of modulus of elasticity in tension thereof, similarly as in Production Example 1, it was found to be 17 MPa. Characteristics of this ethylene·1-hexene copolymer (PE-4) are shown in Table 1.

<Production Example 7>

Polymerization was performed by changing monomer composition and polymerization temperature in polymerization in Production Example 1, so as to attain the composition, density and melt viscosity shown in Table 1. After completion of the reaction, the ethylene·propylene·1-hexene copolymer (PE-9), having content of propylene=14.4% by weight, content of 1-hexene=11.9% by weight, MFR=5.0 g/10 min, density=0.870 g/cm$^3$, and Mz/Mn=3.5, was obtained. As a result of performing measurement of modulus of elasticity in tension thereof, similarly as in Production Example 1, it was found to be 8 MPa. Characteristics of this ethylene/propylene/1-hexene copolymer (PE-9) are shown in Table 1.

Table 1

| | | Polymerization Catalyst | Content of α-olefin (Note) | Density | Mz/Mn | Branch No. | Modulus of elasticity in tension | FR |
|---|---|---|---|---|---|---|---|---|
| | | | wt% | g/cm$^3$ | - | No./total 1000 C | Mpa | |
| PE-1 | Production Example 1 | Metallocene | 32.0 (C6) | 0.865 | 3.7 | 58 | 4 | 5.9 |
| PE-2 | Production Example 2 | Metallocene | 29.5 (C6) | 0.870 | 3.5 | 53 | 8 | 5.9 |
| PE-3 | Production Example 3 | Metallocene | 24.0 (C6) | 0.880 | 3.7 | 44 | 17 | 5.9 |
| PE-4 | Production Example 4 | Metallocene | 35.0 (C4) | 0.870 | 3.5 | 67 | 8 | 5.9 |
| PE-5 | ENGAGE 8200 | - | 36 (C8) | 0.870 | 3.6 | 45 | 8 | 7.5 |
| PE-6 | ENGAGE 8400 | - | 36 (C8) | 0.870 | 3.2 | 45 | 8 | 7.5 |
| PE-7 | Production Example 5 | Metallocene | 19 (C6) | 0.890 | 3.7 | 35 | 34 | 5.9 |
| PE-8 | Production Example 6 | Metallocene | 26.0 (C6) | 0.875 | 3.7 | 48 | 13 | 5.9 |

(continued)

| | | Polymerization Catalyst | Content of α-olefin (Note) | Density | Mz/Mn | Branch No. | Modulus of elasticity in tension | FR |
|---|---|---|---|---|---|---|---|---|
| | | | wt% | g/cm$^3$ | - | No./total 1000 C | Mpa | |
| PE-9 | Production Example 7 | - | 14.4 (C3) 11.9 (C6) | 0.870 | 3.7 | 73.5 | 8 | 6.0 |

(Note): (C3), (C4), (C6) and (C8) are carbon numbers of an α-olefin used as a comonomer.

| | Grade name | MFR | Vinyl acetate content (comonomer content) | |
|---|---|---|---|---|
| | | g/10 min. | wt% | mol % |
| EVA-1 | LV670 | 15 | 28 | 11.2 |
| EVA-2 | LV780 | 30 | 33 | 13.7 |
| EVA-3 | LV570 | 15 | 20 | 7.5 |
| EVA-4 | LV361 | 9.3 | 10 | 3.5 |

(Example 1)

By mixing 5 parts by weight of a copolymer of ethylene and 1-hexene (PE-2) and 95 parts by weight of an ethylene-vinyl acetate copolymer (EVA-1), a resin component was prepared. Relation between density of PE-2 and comonomer content of EVA-1 is within a range of upper limit and lower limit of expression (x) of Fig. 1. To 100 parts by weight of this resin component, 1.5 parts by weight of t-butylperoxy-2-ethylhexyl carbonate (produced by ARKEMA YOSHITOMI, LTD; Luperox (trade mark) TBEC), and 0.3 parts by weight of γ-methacryloxypropyltrimethoxysilane (KBM503, produced by Shin-Etsu Chemical Co., Ltd.), as the silane coupling agent, were blended. By mixing these sufficiently, pelletization was performed using a 40 mm φ single-screw extruder, under condition of a set temperature of 90°C, and an extrusion rate of 12 kg/h.

After preheating the obtained pellet under a condition of 150°C-0 kg/cm$^2$ for 3 minutes, it was pressurized under a condition of 150°C-100 kg/cm$^2$ for 27 minutes (press molding at 150°C for 30 minutes), and then by cooling it with a cooling press set at 30 °C, under a condition of 100 kg/cm$^2$ for 10 minutes, a sheet with a thickness of 0.7 mm was prepared. Haze, light transmittance, modulus of elasticity in tension, heat resistance, adhesive property and steam transmittance of the sheet were measured and evaluated.

In addition, for a separate evaluation of heat resistance, after preheating the sheet under a condition of 160°C-0 kg/cm$^2$ for 3 minutes, it was pressurized under a condition of 160°C-100 kg/cm$^2$ for 27 minutes (press molding at 160°C for 30 minutes), and then by cooling it with a cooling press set at 30°C, under a condition of 100 kg/cm$^2$ for 10 minutes, and a sheet with a thickness of 0.7 mm was prepared. Evaluation results are shown in Table 2.

(Examples 2, 3 and 4)

Sheets were prepared similarly as in Example 1, except that, in Example 2, amount of copolymer (PE-2) of the ethylene and 1-hexene was changed to 20% by weight, and amount of the ethylene-vinyl acetate copolymer (EVA-1) to 80% by weight; in addition, in Example 3, amount of copolymer (PE-2) of the ethylene and 1-hexene was changed to 40% by weight, and amount of the ethylene-vinyl acetate copolymer (EVA-1) to 60% by weight; in addition, in Example 4, amount of copolymer (PE-2) of the ethylene and 1-hexene was changed to 70% by weight, and amount of the ethylene-vinyl acetate copolymer (EVA-1) to 30% by weight.

Haze, light transmittance, modulus of elasticity in tension, heat resistance, adhesive property and steam transmittance of the sheet were measured and evaluated. Evaluation results are shown in Table 2.

(Example 5)

A sheet was prepared similarly as in Example 2, except that, in Example 2, the copolymer (PE-1) of ethylene and 1-hexene was used instead of the copolymer (PE-2) of ethylene and 1-hexene, and the ethylene-vinyl acetate copolymer (EVA-2) was used instead of the ethylene-vinyl acetate copolymer (EVA-1). Relation between density of PE-1 and comonomer content of EVA-2 is within a range of upper limit and lower limit of the expression (x) of Fig. 1. Haze, light transmittance, modulus of elasticity in tension, heat resistance, adhesive property and steam transmittance of the sheet were measured and evaluated. Evaluation results are shown in Table 2.

(Examples 6 and 7)

In Example 6, a sheet was prepared similarly by changing amount of the copolymer (PE-1) of ethylene and 1-hexene to 40% by weight, and amount of the ethylene-vinyl acetate copolymer (EVA-2) to 60% by weight, to Example 5. In addition, in Example 7, a sheet was prepared by changing amount of copolymer (PE-1) of ethylene and 1-hexene to 60% by weight, and amount of the ethylene-vinyl acetate copolymer (EVA-2) to 40% by weight. Haze, light transmittance, modulus of elasticity in tension, heat resistance, adhesive property and steam transmittance of the sheet were measured and evaluated. Evaluation results are shown in Table 2.

(Example 8)

A sheet was prepared similarly as in Example 2, except that, in Example 2, the copolymer (PE-4) of ethylene and 1-hexene was used instead of the copolymer (PE-2) of ethylene and 1-hexene. Haze, light transmittance, modulus of elasticity in tension, heat resistance, adhesive property and steam transmittance of the sheet were measured and evaluated. Evaluation results are shown in Table 2.

(Examples 9 to 11)

Sheets were prepared similarly, except that, in Examples 1 to 3, further, as the hindered amine-type light stabilizer, 0.05 parts by weight of a polymerization product of dimethyl succinate and 4-hydroxy-2,2,6,6-tetramethyl-1-piperidine ethanol (TINUVIN 622LD, produced by BASF AG.), and as the ultraviolet absorbing agent, 0.3 parts by weight of 2-hydroxy-4-n-octoxybenzophenone (CYTEC UV531, produced by Sun Chemical Co. Ltd.) were blended. Haze, light transmittance, modulus of elasticity in tension, heat resistance, adhesive property and steam transmittance of the sheet were measured and evaluated. Evaluation results are shown in Table 2.

(Example 12)

A sheet was prepared similarly as in Example 11, except that, in Example 11, the copolymer (PE-5) of ethylene and 1-octene (ENGAGE8200, produced by Dow Chemical Co., Ltd.) was used instead of the copolymer (PE-2) of ethylene and 1-hexene. Haze, light transmittance, modulus of elasticity in tension, heat resistance, adhesive property and steam transmittance of the sheet were measured and evaluated. Evaluation results are shown in Table 2.

(Example 13)

A sheet was prepared similarly as in Example 11, except that, in Example 11, the copolymer (PE-6) of ethylene and 1-octene (ENGAGE8400, produced by Dow Chemical Co., Ltd.) was used instead of the copolymer (PE-2) of ethylene and 1-hexene. Haze, light transmittance, modulus of elasticity in tension, heat resistance, adhesive property and steam transmittance of the sheet were measured and evaluated. Evaluation results are shown in Table 2.

(Example 14)

A sheet was prepared similarly as in Example 2, except that, in Example 2, the copolymer (PE-1) of ethylene and 1-hexene was used instead of the copolymer (PE-2) of ethylene and 1-hexene. Relation between density of PE-1 and comonomer content of EVA-1 is within a range of upper limit and lower limit of the expression (x) of Fig. 1. Haze, light transmittance, modulus of elasticity in tension, heat resistance, adhesive property and steam transmittance of the sheet were measured and evaluated. Evaluation results are shown in Table 3.

(Example 15)

A sheet was prepared similarly as in Example 2, except that, in Example 2, the copolymer (PE-8) of ethylene and 1-hexene was used instead of the copolymer (PE-2) of ethylene and 1-hexene. Relation between density of PE-8 and comonomer content of EVA-1 is within a range of upper limit and lower limit of the expression (x) of Fig. 1. Haze, light transmittance, modulus of elasticity in tension, heat resistance, adhesive property and steam transmittance of the sheet were measured and evaluated. Evaluation results are shown in Table 3.

(Examples 16 to 18)

In Example 16, a sheet was prepared similarly as in Example 1, except that amount of the copolymer (PE-3) of ethylene and 1-hexene was changed to 20% by weight, and amount of the ethylene-vinyl acetate copolymer (EVA-3) to 80% by weight. In addition, in Example 17, amount of copolymer (PE-9) of ethylene and 1-hexene was changed to 20% by weight, and amount of the ethylene-vinyl acetate copolymer (EVA-1) to 80% by weight; in addition, in Example 18, amount of copolymer (PE-8) of ethylene and 1-hexene was changed to 20% by weight, and amount of the ethylene-vinyl acetate copolymer (EVA-3) to 80% by weight. Relation between density of PE-3, 8 and 9, and comonomer content of EVA-1 and 3 is within a range of upper limit and lower limit of the expression (x) of Fig. 1.

Haze, light transmittance, modulus of elasticity in tension, heat resistance, adhesive property and steam transmittance of the sheet were measured and evaluated. Evaluation results are shown in Table 3.

(Comparative Example 1)

A sheet was prepared similarly as in Example 1, except that only the ethylene-vinyl acetate copolymer (EVA-1) was used, without using the copolymer (PE-2) of ethylene and 1-hexene, as the resin component. Haze, light transmittance, modulus of elasticity in tension, heat resistance, adhesive property and steam transmittance of the sheet were measured and evaluated. Evaluation results are shown in Table 2.

(Comparative Examples 2 and 3)

In Comparative Example 2, a sheet was prepared similarly, in Example 2, except that 20% by weight of the copolymer (PE-3) of ethylene and 1-hexene was used instead of the copolymer (PE-2) of ethylene and 1-hexene, and 80% by weight of the ethylene-vinyl acetate copolymer (EVA-1) was blended; in addition, in Comparative Example 3, amount of ethylene-1-hexene copolymer (PE-3) was changed to 40% by weight, and amount of the ethylene-vinyl acetate copolymer (EVA-1) to 60% by weight. Relation between density of PE-3 and comonomer content of EVA-1 is over the upper limit of the expression (x) of Fig. 1. Haze, light transmittance, modulus of elasticity in tension, heat resistance, adhesive property and steam transmittance of the sheet were measured and evaluated. Evaluation results are shown in Table 2.

(Comparative Examples 4 and 5)

In Comparative Example 4, a sheet was prepared similarly, in Example 5, except that the ethylene-vinyl acetate copolymer (EVA-3) was used instead of the ethylene-vinyl acetate copolymer (EVA-2). In addition, in Comparative Example 5, the ethylene-vinyl acetate copolymer (EVA-4) was used instead of the ethylene-vinyl acetate copolymer (EVA-2). Relation between density of PE-2 and comonomer content of EVA-3 and 4 is outside the lower limit of the expression (x) of Fig. 1.

Haze, light transmittance, modulus of elasticity in tension, heat resistance, adhesive property and steam transmittance of the sheet were measured and evaluated. Evaluation results are shown in Table 3.

(Comparative Example 6)

In Comparative Example 6, a sheet was prepared similarly, in Example 2, except that the copolymer (PE-7) of ethylene and 1-hexene was used instead of the copolymer (PE-2) of ethylene and 1-hexene. Relation between density of PE-7, and comonomer content of EVA-1 is over the upper limit of the expression (x) of Fig. 1. Haze, light transmittance, modulus of elasticity in tension, heat resistance, adhesive property and steam transmittance of the sheet were measured and evaluated. Evaluation results are shown in Table 3.

Table 2

| | | | Example 1 | Example 2 | Example 3 | Example 4 | Example 5 | Example 6 | Example 7 | Example 8 | Example 9 | Example 10 | Example 11 | Example 12 | Example 13 | Comparable Example1 | Comparable Example 2 | Comparable Example 3 |
|---|---|---|---|---|---|---|---|---|---|---|---|---|---|---|---|---|---|---|
| ethylene α olefin copolymer | PE-1 | % by weight | - | - | - | - | 20 | 40 | 60 | - | - | - | - | - | - | - | - | - |
| | PE-2 | | 5 | 20 | 40 | 70 | - | - | - | - | 5 | 20 | 40 | - | - | - | - | - |
| | PE-3 | | - | - | - | - | - | - | - | - | - | - | - | - | - | - | 20 | 40 |
| | PE-4 | | - | - | - | - | - | - | - | 20 | - | - | - | - | - | - | - | - |
| | PE-5 | | - | - | - | - | - | - | - | - | - | - | - | 40 | - | - | - | - |
| | PE-6 | | - | - | - | - | - | - | - | - | - | - | - | - | 40 | - | - | - |
| | PE-7 | | - | - | - | - | - | - | - | - | - | - | - | - | - | - | - | - |
| | PE-8 | | - | - | - | - | - | - | - | - | - | - | - | - | - | - | - | - |
| | PE-9 | | - | - | - | - | - | - | - | - | - | - | - | - | - | - | - | - |
| ethylene vinyl acetate copolymer | EVA-1 | | 95 | 80 | 60 | 30 | - | - | - | 80 | 95 | 80 | 60 | 60 | 60 | 100 | 80 | 60 |
| | EVA-2 | | - | - | - | - | 80 | 60 | 40 | - | - | - | - | - | - | - | - | - |
| | EVA-3 | | - | - | - | - | - | - | - | - | - | - | - | - | - | - | - | - |
| | EVA-4 | | - | - | - | - | - | - | - | - | - | - | - | - | - | - | - | - |
| Satisfaction of expression (x) | | | ○ | ○ | ○ | ○ | ○ | ○ | ○ | ○ | ○ | ○ | ○ | ○ | ○ | - | × | × |
| Satisfaction of expression (a) | | | ○ | ○ | ○ | ○ | ○ | ○ | ○ | ○ | ○ | ○ | ○ | × | × | - | ○ | ○ |
| Organic peroxide | | | 1.5 | 1.5 | 1.5 | 1.5 | 1.5 | 1.5 | 1.5 | 1.5 | 1.5 | 1.5 | 1.5 | 1.5 | 1.5 | 1.5 | 1.5 | 1.5 |
| Silane coupling agent | | | 0.3 | 0.3 | 0.3 | 0.3 | 0.3 | 0.3 | 0.3 | 0.3 | 0.3 | 0.3 | 0.3 | 0.3 | 0.3 | 0.3 | 0.3 | 0.3 |
| Hindered amine | | | | | | | | | | | 0.05 | 0.05 | 0.05 | 0.05 | 0.05 | - | - | - |
| UV absorbing agent | | | - | - | - | | - | - | - | - | 0.3 | 0.3 | 0.3 | 0.3 | 0.3 | - | - | - |
| Haze | | % | 0.5 | 0.6 | 0.9 | 1.5 | 1.5 | 1.9 | 1.5 | 0.6 | 0.5 | 0.6 | 0.9 | 0.9 | 0.9 | 0.6 | 22 | 29 |

(continued)

| | | Example 1 | Example 2 | Example 3 | Example 4 | Example 5 | Example 6 | Example 7 | Example 8 | Example 9 | Example 10 | Example 11 | Example 12 | Example 13 | Comparable Example1 | Comparable Example 2 | Comparable Example 3 |
|---|---|---|---|---|---|---|---|---|---|---|---|---|---|---|---|---|---|
| Light transmittance | % | 92 | 92 | 92 | 92 | 92 | 92 | 92 | 92 | 92 | 92 | 92 | 92 | 92 | 92 | 92 | 91 |
| Modulus of elasticity in tension | Mpa | 15 | 13 | 12 | 9 | 8 | 7 | 6 | 13 | 15 | 13 | 12 | 12 | 12 | 14 | 14 | 16 |
| Heat resistance (150°C×30min) | - | ○ | ○ | ○ | ○ | ○ | ○ | ○ | ○ | ○ | ○ | ○ | Δ | Δ | ○ | ○ | ○ |
| Heat resistance (160°C×30min) | - | ○ | ○ | ○ | ○ | ○ | ○ | ○ | ○ | ○ | ○ | ○ | ○ | ○ | ○ | ○ | ○ |
| Adhesive property (to glass) | | ○ | ○ | ○ | ○ | ○ | ○ | ○ | ○ | ○ | ○ | ○ | ○ | ○ | ○ | ○ | ○ |
| Steam transmittance | g/(m²24 h) | 17 | 14 | 8.9 | 5.0 | 16 | 11 | 6.0 | 14 | 17 | 14 | 8.9 | 9.0 | 9.1 | 20 | 15 | 7.8 |

Table 3

| | | | Example 14 | Example 15 | Example 16 | Example 17 | Example 18 | Comparable Example 4 | Comparable Example 5 | Comparable Example 6 |
|---|---|---|---|---|---|---|---|---|---|---|
| ethylene α-olefin copolymer | PE-1 | % by weight | 20 | - | - | - | - | 20 | 20 | - |
| | PE-2 | | - | - | - | - | - | - | - | - |
| | PE-3 | | - | - | 20 | - | - | - | - | - |
| | PE-4 | | - | - | - | - | - | - | - | - |
| | PE-5 | | - | - | - | - | - | - | - | - |
| | PE-6 | | - | - | - | - | - | - | - | - |
| | PE-7 | | - | - | - | - | - | - | - | 20 |
| | PE-8 | | - | 20 | - | - | 20 | - | - | - |
| | PE-9 | | - | - | - | 20 | - | - | - | - |
| ethylene vinyl acetate copolymer | EVA-1 | | 80 | 80 | - | 80 | - | - | - | 80 |
| | EVA-2 | | - | - | - | - | - | - | - | - |
| | EVA-3 | | - | - | 80 | - | 80 | 80 | - | - |
| | EVA-4 | | - | - | - | - | - | - | 80 | - |
| Satisfaction of expression (x) | | | ○ | ○ | ○ | ○ | ○ | × | × | × |
| Satisfaction of expression (a) | | | ○ | ○ | ○ | ○ | ○ | ○ | ○ | ○ |
| Organic peroxide | | Parts by weight | 1.5 | 1.5 | 1.5 | 1.5 | 1.5 | 1.5 | 1.5 | 1.5 |
| Silane coupling agent | | | 0.3 | 0.3 | 0.3 | 0.3 | 0.3 | 0.3 | 0.3 | 0.3 |
| Hindered amine | | | - | - | - | - | - | - | - | - |
| UV absorbing agent | | | - | - | - | - | - | - | - | - |
| Haze | | % | 4.2 | 3.9 | 3.2 | 2.2 | 7.9 | 51 | 40 | 34 |
| Light transmittance | | % | 92 | 92 | 90 | 93 | 90 | 88 | 73 | 89 |
| Modulus of elasticity in tension | | Mpa | 13 | 16 | 35 | 17 | 34 | 31 | 56 | 23 |
| Heat resistance (150°C×30min) | | - | ○ | ○ | ○ | ○ | ○ | ○ | ○ | ○ |
| Heat resistance (160°C×30min) | | - | ○ | ○ | ○ | ○ | ○ | ○ | ○ | ○ |
| Adhesive property (to glass) | | | ○ | ○ | ○ | ○ | ○ | ○ | ○ | ○ |

EP 2 587 551 B1

23

(continued)

| | | Example 14 | Example 15 | Example 16 | Example 17 | Example 18 | Comparable Example 4 | Comparable Example 5 | Comparable Example 6 |
|---|---|---|---|---|---|---|---|---|---|
| Steam transmittance | g/(m$^2$ 24h) | 15 | 14 | 10 | 14 | 9 | 9 | 4 | 12 |

[Evaluation]

As a result, as is clear from Tables 2 and 3, in Examples 1 to 18 of the present invention, because resin compositions containing a specific ethylene·α-olefin copolymer (A) and a copolymer (B) of ethylene and a functional group-containing monomer were used as a material of the solar cell encapsulant, sheets obtained by extrusion molding this has small haze and steam transmittance, are superior in light transmittance and modulus of elasticity in tension. And also, due to containing the silane coupling agent (C) and the organic peroxide (B), they are superior in heat resistance and adhesive property as well. On the other hand, in Comparative Example 1, because of using only the ethylene-vinyl acetate copolymer, without using the ethylene·1-hexene copolymer, as the resin component, steam transmittance became inferior.

In Comparative Examples 2 to 6, because of using the ethylene·1-hexene copolymer and the ethylene-vinyl acetate copolymer not satisfying condition of the expression (x) of the present invention, as the resin component, transparency became inferior.

INDUSTRIAL APPLICATION

The solar cell encapsulant of the present invention is utilized as a material of the solar cell module, requiring superior transparency and small steam transmittance, as well as superior light transmittance, flexibility, heat resistance, adhesive property or the like. In addition, because of having high flexibility, it is useful as the solar cell encapsulant using a flexible film as a substrate, as well as because of having high adhesive property to glass, it is also useful as the solar cell encapsulant using a glass plate as a substrate. In addition, it can also be utilized as the encapsulant of an IC (integrated circuit).

**Claims**

1. A solar cell encapsulant, **characterized by** using a resin composition comprising the following components (A) to (D), satisfying the following expression (x), as resin components:

   Component (A): an ethylene·α-olefin copolymer having the characteristics of the following (a1) (a1) Density: 0.860 to 0.900 g/cm$^3$;
   Component (B): copolymer of ethylene-a functional group-containing monomer;
   Component (C): a silane coupling agent;
   Component (D): an organic peroxide;

   $$\text{Expression (x):} \quad -480 \times [d] + 425 \leq [CM] \leq -480 \times [d] + 433$$

   (wherein [d] represents the density of the component (A); and [CM] represents a comonomer content (mol%) of the component (B)).

2. The solar cell encapsulant according to claim 1, **characterized in that** the component (A) is the ethylene·α-olefin copolymer having further the characteristics of the following (a2):

   (a2) a ratio, (Mz/Mn), of Z average molecular weight (Mz) and number average molecular weight (Mn), determined by a gel permeation chromatography (GPC), is 8.0 or less.

3. The solar cell encapsulant according to claim 1 or 2, **characterized in that** the resin component satisfies the following expression (x'):

   $$\text{Expression (x')} \quad -480 \times [d] + 426 \leq [CM] \leq -480 \times [d] + 432$$

   (wherein [d] represents density of the component (A); and [CM] represents comonomer content (mol%) of the component (B)).

**4.** The solar cell encapsulant according to any of claims 1 to 3, **characterized in that** the component (A) has further the characteristics of the following (a3):

(a3) A branch number (N) derived from a comonomer in a polymer satisfies the following expression (a):

$$\text{Expression (a): } N \geq -0.67 \times E + 53$$

(wherein N represents the branch number per 1000 carbon atoms in a main chain and a side chain in total, measured by NMR; and E represents modulus of elasticity in tension of a sheet-like resin composition measured in accordance with ISO1184-1983).

**5.** The solar cell encapsulant according to claim 4, **characterized in that** the component (A) satisfies the following expression (a'):

$$\text{Expression (a'): } -0.67 \times E + 100 \geq N \geq -0.67 \times E + 53$$

(wherein N represents the branch number per 1000 carbon atoms in a main chain and a side chain in total, measured by NMR; and E represents modulus of elasticity in tension of a sheet-like resin composition measured in accordance with ISO1184-1983).

**6.** The solar cell encapsulant according to claim 4, **characterized in that** the component (A) satisfies the following expression (a"):

$$\text{Expression (a''): } -0.67 \times E + 80 \geq N \geq -0.67 \times E + 53$$

(wherein N represents the branch number per 1000 carbon atoms in a main chain and a side chain in total, measured by NMR; and E represents modulus of elasticity in tension of a sheet-like resin composition measured in accordance with ISO1184-1983).

**7.** The solar cell encapsulant according to any of claims 1 to 3, **characterized in that** the component (A) has further the characteristics of the following (a4):

(a4) a flow ratio (FR): a ratio, $(I_{10}/I_{2.16})$, of $I_{10}$ which is an MFR measurement value at 190°C under a load of 10 kg, and $I_{2.16}$ which is an MFR measurement value at 190°C under a load of 2.16 kg, of below 7.0.

**8.** The solar cell encapsulant according to claim 7, **characterized in that** characteristics (a4) of the component (A), the flow ratio (FR), is 5.0 to 6.2.

**9.** The solar cell encapsulant according to any of claims 1 to 8, **characterized in that** the resin component is composed of the component (A) in an amount of 1% by weight or more and less than 70% by weight, and the component (B) in an amount over 30% by weight and 99% by weight or less.

**10.** The solar cell encapsulant according to any of claims 1 to 9, **characterized in that** the component (B) is one or more kinds of copolymers of ethylene-a functional group-containing monomer, selected from
an ethylene-vinyl acetate copolymer,
an ethylene-(meth)acrylate ester copolymer,
an ethylene-(meth)acrylic acid copolymer,
an ethylene-(meth)acrylate ester multi-component copolymer, and an ethylene-(meth)acrylic acid multi-component copolymer.

**11.** The solar cell encapsulant according to claim 10, **characterized in that** the component (B) is an ethylene-vinyl acetate copolymer having the characteristics of the following (b1):

(b1) content of vinyl acetate is 20 to 40% by weight.

**12.** The solar cell encapsulant according to any of claims 1 to 11, **characterized in that** content of the component (C) is 0.01 to 5 parts by weight, relative to 100 parts by weight of the resin component composed of the component (A) and the component (B).

**13.** The solar cell encapsulant according to any of claims 1 to 12, **characterized in that** the content of component (D) is 0.2 to 5 parts by weight, relative to 100 parts by weight of the resin component composed of the component (A) and the component (B).

**14.** The solar cell encapsulant according to any of claims 1 to 13, **characterized in that** the component (A) is an ethylene·propylene copolymer, an ethylene·1-butene copolymer or an ethylene·1-hexene copolymer.

**15.** The solar cell encapsulant according to any of claims 1 to 13, **characterized in that** the component (A) is an ethylene·propylene·1-hexene terpolymer.

**16.** A solar cell module using the solar cell encapsulant according to any of claims 1 to 15.


**Patentansprüche**

**1.** Solarzelleneinkapselungsmaterial, **gekennzeichnet durch** die Verwendung einer Harzzusammensetzung umfassend die folgenden Komponenten (A) bis (D), die den folgenden Ausdruck (x) erfüllen, als Harzkomponenten:

Komponente (A): ein Ethylen·$\alpha$-Olefin-Copolymer mit den folgenden Eigenschaften (a1)
(a1) Dichte: 0,860 bis 0,900 g/cm$^3$,
Komponente (B): Ethylen-funktionelle Gruppe-haltiges Monomer-Copolymer,
Komponente (C): einen Silan-Haftvermittler,
Komponente (D): ein organisches Peroxid,

$$\text{Ausdruck (x): } -480x[d]+425 \leq [CM] \leq -480x[d]+433$$

(worin [d] die Dichte der Komponente (A) darstellt und [CM] einen Comonomergehalt (mol%) der Komponente (B) darstellt).

**2.** Solarzelleneinkapselungsmaterial gemäß Anspruch 1, **dadurch gekennzeichnet, dass** die Komponente (A) das Ethylen·$\alpha$-Olefin-Copolymer ist, welches ferner die folgenden Eigenschaften (a2) aufweist:

(a2) ein Verhältnis (Mz/Mn), von Z-gemitteltem Molekulargewicht (Mz) zu zahlengemitteltem Molekulargewicht (Mn), bestimmt durch Gelpermeationschromatographie (GPC), beträgt 8,0 oder weniger.

**3.** Solarzelleneinkapselungsmaterial gemäß Anspruch 1 oder 2, **dadurch gekennzeichnet, dass** die Harzkomponente den folgenden Ausdruck (x') erfüllt:

$$\text{Ausdruck (x') } -480x[d]+426 \leq [CM] \leq -480x[d]+432$$

(worin [d] die Dichte der Komponente (A) darstellt und [CM] den Comonomergehalt (mol%) der Komponente (B) darstellt).

**4.** Solarzelleneinkapselungsmaterial gemäß irgendeinem der Ansprüche 1 bis 3, **dadurch gekennzeichnet, dass** die Komponente (A) ferner die folgenden Eigenschaften (a3) aufweist:

(a3) eine Verzweigungszahl (N), die aus einem Comonomer in einem Polymer abgeleitet ist, erfüllt den folgenden Ausdruck (a):

$$\text{Ausdruck (a): } N \geq -0{,}67xE+53$$

(worin N die Verzweigungszahl pro insgesamt 1000 Kohlenstoffatomen in einer Hauptkette und einer Seitenkette, gemessen durch NMR, darstellt, und E einen Zug-Elastizitätsmodul einer folienartigen Harzzusammensetzung, gemessen gemäß ISO1184-1983, darstellt).

5. Solarzelleneinkapselungsmaterial gemäß Anspruch 4, **dadurch gekennzeichnet, dass** die Komponente (A) den folgenden Ausdruck (a') erfüllt:

$$\text{Ausdruck (a'): } -0{,}67xE+100 \geq N \geq -0{,}67xE+53$$

(worin N die Verzweigungszahl pro insgesamt 1000 Kohlenstoffatomen in einer Hauptkette und einer Seitenkette, gemessen durch NMR, darstellt, und E einen Zug-Elastizitätsmodul einer folienartigen Harzzusammensetzung, gemessen gemäß ISO1184-1983, darstellt).

6. Solarzelleneinkapselungsmaterial gemäß Anspruch 4, **dadurch gekennzeichnet, dass** die Komponente (A) den folgenden Ausdruck (a") erfüllt:

$$\text{Ausdruck (a''): } -0{,}67xE+80 \geq N \geq -0{,}67xE+53$$

(worin N die Verzweigungszahl pro insgesamt 1000 Kohlenstoffatomen in einer Hauptkette und einer Seitenkette, gemessen durch NMR, darstellt, und E einen Zug-Elastizitätsmodul einer folienartigen Harzzusammensetzung, gemessen gemäß ISO1184-1983, darstellt).

7. Solarzelleneinkapselungsmaterial gemäß irgendeinem der Ansprüche 1 bis 3, **dadurch gekennzeichnet, dass** die Komponente (A) ferner die folgenden Eigenschaften (a4) aufweist:

(a4) ein Fließverhältnis (FR): ein Verhältnis ($I_{10}/I_{2,16}$) von $I_{10}$, das ein MFR-Messwert bei 190°C unter einer Last von 10 kg ist, zu $I_{2,16}$, das ein MFR-Messwert bei 190°C unter einer Last von 2,16 kg ist, von unterhalb 7,0.

8. Solarzelleneinkapselungsmaterial gemäß Anspruch 7, **dadurch gekennzeichnet, dass** die Eigenschaft (a4) der Komponente (A), das Fließverhältnis (FR), 5,0 bis 6,2 beträgt.

9. Solarzelleneinkapselungsmaterial gemäß irgendeinem der Ansprüche 1 bis 8, **dadurch gekennzeichnet, dass** die Harzkomponente aus der Komponente (A) in einer Menge von 1 Gew.% oder mehr und weniger als 70 Gew.% und der Komponente (B) in einer Menge von mehr als 30 Gew.% und 99 Gew.% oder weniger zusammengesetzt ist.

10. Solarzelleneinkapselungsmaterial gemäß irgendeinem der Ansprüche 1 bis 9, **dadurch gekennzeichnet, dass** die Komponente (B) eine oder mehrere Arten von Ethylen-funktionelle Gruppe-haltiges Monomer-Copolymeren ist, die aus einem Ethylen-Vinylacetat-Copolymer, einem Ethylen-(Meth)acrylatester-Copolymer, einem Ethylen-(Meth)acrylsäure-Copolymer, einem Ethylen-(Meth)acrylatester-Multikomponentencopolymer und einem Ethylen-(Meth)acrylsäure-Multikomponentencopolymer ausgewählt sind.

11. Solarzelleneinkapselungsmaterial gemäß Anspruch 10, **dadurch gekennzeichnet, dass** die Komponente (B) ein Ethylen-Vinylacetat-Copolymer mit den folgenden Eigenschaften (b1) ist:

(b1) der Vinylacetat-Gehalt beträgt 20 bis 40 Gew.%.

12. Solarzelleneinkapselungsmaterial gemäß irgendeinem der Ansprüche 1 bis 11, **dadurch gekennzeichnet, dass** der Gehalt der Komponente (C) 0,01 bis 5 Gewichtsteile bezogen auf 100 Gewichtsteile der Harzkomponente, die aus der Komponente (A) und der Komponente (B) zusammengesetzt ist, beträgt.

13. Solarzelleneinkapselungsmaterial gemäß irgendeinem der Ansprüche 1 bis 12, **dadurch gekennzeichnet, dass** der Gehalt der Komponente (D) 0,2 bis 5 Gewichtsteile bezogen auf 100 Gewichtsteile der Harzkomponente, die aus der Komponente (A) und der Komponente (B) zusammengesetzt ist, beträgt.

**14.** Solarzelleneinkapselungsmaterial gemäß irgendeinem der Ansprüche 1 bis 13, **dadurch gekennzeichnet, dass** die Komponente (A) ein Ethylen·Propylen-Copolymer, ein Ethylen·1-Buten-Copolymer oder ein Ethylen·1-Hexen-Copolymer ist.

**15.** Solarzelleneinkapselungsmaterial gemäß irgendeinem der Ansprüche 1 bis 13, **dadurch gekennzeichnet, dass** die Komponente (A) ein Ethylen·Propylen·1-Hexen-Terpolymer ist.

**16.** Solarzellenmodul, das das Solarzelleneinkapselungsmaterial gemäß irgendeinem der Ansprüche 1 bis 15 verwendet.

**Revendications**

**1.** Encapsulant de cellule solaire, **caractérisé par** l'utilisation d'une composition de résine comprenant les composants (A) à (D) suivants, satisfaisant l'expression (x) suivante, comme composants de résine,
Composant (A) : un copolymère d'éthylène·$\alpha$-oléfine ayant les caractéristiques de (a1) suivant
(a1) Densité : 0,860 à 0,900 g/cm$^3$ ;
Composant (B) : copolymère d'éthylène-un monomère contenant un groupe fonctionnel ;
Composant (C) : un agent de couplage au silane ; Composant (D) : un peroxyde organique ;

$$\text{Expression (x) : } -480 \times [d] + 425 \leq [CM] \leq -480 \times [d] + 433$$

(où [d] représente la densité du composant (A) ; et [CM] représente la teneur en comonomère (% en moles) du composant (B)).

**2.** Encapsulant de cellule solaire selon la revendication 1, **caractérisé en ce que** le composant (A) est le copolymère d'éthylène.$\alpha$-oléfine ayant en outre les caractéristiques de (a2) suivant :

(a2) un rapport, (Mz/Mn), d'un poids moléculaire moyen en Z (Mz) et d'un poids moléculaire moyen en nombre (Mn), déterminé par une chromatographie par perméation de gel (GPC), est inférieur ou égal à 8,0.

**3.** Encapsulant de cellule solaire selon la revendication 1 ou 2, **caractérisé en ce que** le composant de résine satisfait l'expression (x') suivante :

$$\text{Expression (x') : } -480 \times [d] + 426 \leq [CM] \leq -480 \times [d] + 432$$

(où [d] représente la densité du composant (A) ; et [CM] représente la teneur en comonomère (% en moles) du composant (B)).

**4.** Encapsulant de cellule solaire selon l'une des revendications 1 à 3, **caractérisé en ce que** le composant (A) a en outre les caractéristiques de (a3) suivant :

(a3) un nombre de branches (N) dérivé d'un comonomère dans un polymère satisfait l'expression (a) suivante :

$$\text{Expression (a) : } N \geq -0,67 \times E + 53$$

(où N représente le nombre de branches par 1000 atomes de carbone dans une chaîne principale et une chaîne latérale au total, mesuré par RMN ; et E représente un module d'élasticité en tension d'une composition de résine en forme de feuille mesuré selon la norme IS01184-1983).

**5.** Encapsulant de cellule solaire selon la revendication 4, **caractérisé en ce que** le composant (A) satisfait l'expression (a') suivante :

$$\text{Expression (a') : } -0,67{\times}E+100 \geq N \geq -0,67{\times}E+53$$

(où N représente le nombre de branches par 1000 atomes de carbone dans une chaîne principale et une chaîne latérale au total, mesuré par RMN ; et E représente un module d'élasticité en tension d'une composition de résine en forme de feuille mesuré selon la norme ISO1184-1983).

**6.** Encapsulant de cellule solaire selon la revendication 4, **caractérisé en ce que** le composant (A) satisfait l'expression (a") suivante :

$$\text{Expression (a'') : } -0,67{\times}E+80 \geq N \geq -0,67{\times}E+53$$

(où N représente le nombre de branches par 1000 atomes de carbone dans une chaîne principale et une chaîne latérale au total, mesuré par RMN ; et E représente un module d'élasticité en tension d'une composition de résine en forme de feuille mesuré selon la norme IS01184-1983)

**7.** Encapsulant de cellule solaire selon l'une des revendications 1 à 3, **caractérisé en ce que** le composant (A) a en outre les caractéristiques de (a4) suivant :

(a4) un rapport de débit (FR) : un rapport ($I_{10}/I_{2,16}$), de $I_{10}$ qui est une valeur de mesure de MFR à 190°C sous une charge de 10 kg, et de $I_{2,16}$ qui est une valeur de mesure de MFR à 190°C sous une charge de 2,16 kg, inférieur à 7,0.

**8.** Encapsulant de cellule solaire selon la revendication 7, **caractérisé en ce que** les caractéristiques (a4) du composant (A), le rapport de débit (FR), est de 5,0 à 6,2.

**9.** Encapsulant de cellule solaire selon l'une des revendications 1 à 8, **caractérisé en ce que** le composant de résine est composé du composant (A) en une quantité supérieure ou égale à 1% et inférieure à 70% en poids, et du composant (B) en une quantité supérieure à 30% en poids et inférieure ou égale à 99% en poids.

**10.** Encapsulant de cellule solaire selon l'une des revendications 1 à 9, **caractérisé en ce que** le composant (B) représente un ou plusieurs type(s) de copolymères d'éthylène-un monomère contenant un groupe fonctionnel, sélectionné(s) parmi
un copolymère d'éthylène-acétate de vinyle,
un copolymère d'éthylène-ester de (méth)acrylate,
un copolymère d'éthylène-acide (méth)acrylique,
un copolymère multi-composant d'éthylène-ester de (méth)acrylate,
et un copolymère multi-composant d'éthylène-acide (méth)acrylique.

**11.** Encapsulant de cellule solaire selon la revendication 10, **caractérisé en ce que** le composant (B) est un copolymère d'éthylène-acétate de vinyle ayant les caractéristiques de (b1) suivant :

(b1) la teneur en acétate de vinyle est de 20 à 40% en poids.

**12.** Encapsulant de cellule solaire selon l'une des revendications 1 à 11, **caractérisé en ce que** la teneur du composant (C) est de 0,01 à 5 parties en poids, par rapport à 100 parties en poids du composant de résine composé du composant (A) et du composant (B).

**13.** Encapsulant de cellule solaire selon l'une des revendications 1 à 12, **caractérisé en ce que** la teneur du composant (D) est de 0,2 à 5 parties en poids, par rapport à 100 parties en poids du composant de résine composé du composant (A) et du composant (B).

**14.** Encapsulant de cellule solaire selon l'une des revendications 1 à 13, **caractérisé en ce que** le composant (A) est un copolymère d'éthylène.propylène, un copolymère d'éthylène.1-butène ou un copolymère d'éthylène.1-hexène.

15. Encapsulant de cellule solaire selon l'une des revendications 1 à 13, **caractérisé en ce que** le composant (A) est un terpolymère d'éthylène.propylène.1-hexène.

16. Module de cellule solaire utilisant l'encapsulant de cellule solaire selon l'une des revendications 1 à 15.

Fig. 1

Fig. 2

Branch number N of component (A)
(number/total 1000 C)

Modulus of elasticity in tension E (MPa)
of a sheet-like resin composition

Expression (A): $N \geq -0.87 \times E + 53$

Region of the broken line and
above the broken line

PE-9 and the like

PE-1 and the like

PE-2 and the like

PE-8

PE-5 and the like

PE-3

PE-7 and the like

EP 2 587 551 B1

**REFERENCES CITED IN THE DESCRIPTION**

**Patent documents cited in the description**

- JP 9116182 A
- JP 2006210906 A
- JP 2001332750 A
- JP 2000091611 A
- JP 2010504647 A
- EP 2270077 A
- WO 2009125685 A
- WO 200836708 A
- WO 2010131716 A
- US 201248354 A
- JP 7508545 A